(19) Europäisches Patentamt
European Patent Office
Office européen des brevets

(11) **EP 2 267 193 A1**

(12) # EUROPEAN PATENT APPLICATION
published in accordance with Art. 153(4) EPC

(43) Date of publication:
**29.12.2010  Bulletin 2010/52**

(21) Application number: **09726041.8**

(22) Date of filing: **18.03.2009**

(51) Int Cl.:
*C30B 29/16* [(2006.01)]  *C30B 19/02* [(2006.01)]
*C30B 33/00* [(2006.01)]  *H01L 21/368* [(2006.01)]

(86) International application number:
**PCT/JP2009/055301**

(87) International publication number:
**WO 2009/119411 (01.10.2009 Gazette 2009/40)**

(84) Designated Contracting States:
**AT BE BG CH CY CZ DE DK EE ES FI FR GB GR
HR HU IE IS IT LI LT LU LV MC MK MT NL NO PL
PT RO SE SI SK TR**
Designated Extension States:
**AL BA RS**

(30) Priority:  **26.03.2008  JP 2008080629
26.03.2008  JP 2008080639**

(71) Applicants:
• **Mitsubishi Gas Chemical Company, Inc.
Tokyo 100-8324 (JP)**
• **National Institute for Materials Science
Tsukuba-shi
Ibaraki 305-0047 (JP)**

(72) Inventors:
• **SEKIWA, Hideyuki
Tokyo 125-0051 (JP)**

• **KOBAYASHI, Jun
Tokyo 125-0051 (JP)**
• **MIYAMOTO, Miyuki
Tokyo 125-0051 (JP)**
• **OHASHI, Naoki
Tsukuba-shi
Ibaraki 305-0047 (JP)**
• **SAKAGUCHI, Isao
Tsukuba-shi
Ibaraki 305-0047 (JP)**
• **WADA, Yoshiki
Tsukuba-shi
Ibaraki 305-0047 (JP)**

(74) Representative: **Cabinet Plasseraud
52, rue de la Victoire
75440 Paris Cedex 09 (FR)**

(54) **PROCESS FOR PRODUCING ZNO SINGLE CRYSTAL, SELF-SUPPORTING ZNO SINGLE-CRYSTAL WAFER OBTAINED BY THE SAME, SELF-SUPPORTING WAFER OF MG-CONTAINING ZNO MIXED SINGLE CRYSTAL, AND PROCESS FOR PRODUCING MG-CONTAINING ZNO MIXED SINGLE CRYSTAL FOR USE IN THE SAME**

(57) A ZnO single crystal can be grown on a seed crystal substrate using a liquid phase epitaxial growth method by mixing and melting ZnO as a solute and a solvent, bringing the crystal substrate into direct contact with the resultant melt, and pulling up the seed crystal substrate continuously or intermittently. A self-supporting Mg-containing ZnO mixed single crystal wafer can be obtained as follows. A Mg-containing ZnO mixed single crystal is grown using a liquid phase epitaxial growth method by mixing and melting ZnO and MgO forming a solute and a solvent, then bringing a seed crystal substrate into direct contact with the resultant melt, and pulling up the seed crystal substrate continuously or intermittently. Then, the self-supporting Mg-containing ZnO mixed single crystal wafer is obtained by removing the substrate by polishing or etching, and polishing or etching a surface, on the side of -c plane, of the single crystal grown by the liquid phase epitaxial growth method.

EP 2 267 193 A1

**Description**

TECHNICAL FIELD

The present invention relate to a ZnO-based semiconductor material, and specifically to a method for producing a ZnO single crystal useful in the field of optics and the field of electric and electronic industries, and a self-supporting ZnO single crystal wafer obtained by the same. The present invention also relates specifically to a self-supporting Mg-containing ZnO mixed single crystal wafer having a high composition uniformity useful in field of optics and the field of electric and electronic industries, and a method for producing a Mg-containing ZnO mixed single crystal usable for the same.

BACKGROUND ART

Conventionally, Si, GaAs, GaN and the like have been used for optical and electronic devices having various functions. Recently, light emitting devices and electronic devices using GaN have been actively developed. In the meantime, regarding oxides, ZnO has been used for varistors, gas sensors, sunscreen items and the like, and recently is a target of attention because there is an attempt to apply ZnO for optical devices, electronic devices, piezoelectric devices, transparent electrodes and the like owing to optical characteristics, electronic device characteristics and piezoelectric characteristics thereof. Especially, it is known that ZnO has a direct transfer type bandgap of 3.3 to 3.4 eV like GaN and emits ultraviolet light of 380 nm. Thus, research and development has been actively conducted to use and apply ZnO for light emitting semiconductors for emitting light of a short wavelength in the range from blue light to ultraviolet light.

Regarding a ZnO-based semiconductor single crystal laminate body, a modulation doping method is one method for putting semiconductors into contact with each other in a state where no electric field is applied, unlike in a field effect transistor, to cause electric charge separation,. For example, Japanese Laid-Open Patent Publication No. 2005-72067 (Patent Document 1) discloses the following: a semiconductor having a wide bandgap and a high electron concentration and a semiconductor having a narrow bandgap and a high electron mobility are stacked together to induce electric charge transfer from the semiconductor having a high electron concentration to the semiconductor having a high electron mobility; and thus electrons are transferred in a layer having a high mobility, thus to realize a semiconductor material having both of a high electron concentration and a high electron mobility.

In addition, it is shown that during the process of producing an ultraviolet light emitting device using ZnO, $Zn_{1-x}Mg_xO$, which is a mixed crystal of group II-VI semiconductors having a wide bandgap is obtained at a growth temperature of 600°C using a pulse laser deposition method, and a bandgap wider than that of ZnO is obtained by adjusting the composition x (A. Ohtomo et al., Applied Physics Letters, Vol. 72, No. 19, 11 May 1998, pp. 2466-2468) (Non-patent Document 1). Considering that ZnO is to be applied to a light emitting device, a double-hetero structure needs to be adopted in order to increase the light emission efficiency. By adopting such a structure, the efficiency of confining carriers or taking out light is improved and so the light emission efficiency is improved. In order to form the above-mentioned structure, the light emitting layer needs to be held between an n layer and a p layer having a wide bandgap. For realizing this, a ZnO mixed single crystal having a wider bandgap than that of ZnO is needed, and an n-type ZnO single crystal and a p-type ZnO single crystal are also needed.

In order to exhibit electronic device characteristics or optical characteristics, the ZnO-based semiconductor single crystal needs to have a high crystallinity. Conventionally, a ZnO-based semiconductor single crystal is grown by a gas phase growth method using an insulating substrate of ZnO, $ScAlMgO_4$, sapphire or the like. In order to realize a high crystallinity, a substrate which is not lattice-mismatched very much with the ZnO-based semiconductor single crystal needs to be used. Therefore, it is desirable to use a ZnO single crystal for the substrate. However, the ZnO single crystal of a commercially available ZnO single crystal substrate is grown by a hydrothermal synthesis method, and so it is unavoidable that the ZnO single crystal is contaminated with Li from LiOH used as a mineralizing agent. Li in ZnO is easily diffusable and so has a problem of transferring when the device is working and thus destabilizing the device operation. Preferably, the amount of Li in the ZnO substrate is as small as possible. In such a situation, Japanese Laid-Open Patent Publication No. 2007-204324 (Patent Document 2) discloses a technique for decreasing the Li concentration in the hydrothermally synthesized substrate by post gloss anneal. It is described in this publication that by annealing Li of about $8.4 \times 10^{16}$ pieces/cm³ to $2.0 \times 10^{17}$ pieces/cm³ at 1300°C for about 2 hours, the Li concentration in ZnO can be decreased to about $9 \times 10^{14}$ pieces/cm³ According to this publication, it is possible to decrease the Li concentration by annealing. However, this technique has problems that an annealing step is required and thus the steps are complicated, and that even if annealing is done, Li of about $1 \times 10^{15}$ pieces/cm³ remains.

In the meantime, if a ZnO-based semiconductor single crystal which is grown to be thick can be put into a self-supporting state by removing the hydrothermally synthesized substrate by polishing or etching, contamination with Li impurities from the hydrothermally synthesized substrate can be significantly reduced. Moreover, if the ZnO-based semiconductor single crystal can be put into a self-supporting state by being doped, during the growth, with impurities capable of providing conductivity, a conductive self-supporting ZnO single crystal wafer having a low Li concentration and having conductivity can be provided.

The present inventors have filed a patent application for "method for producing ZnO single crystal by a liquid phase growth method" (Pamphlet of International Publication 2007/100146) (Patent Document 3). Using the invention described in this publication, a thick ZnO can be grown. However, it was found that when a self-supporting ZnO single crystal is produced in a crack-free state using this invention, the yield is low. As a result of active studies of the present inventors, it was found that the yield is lowered by the deposition of flux in the vicinity of a Pt jig/tool used for holding the substrate. As described above, using the method according to the invention for which a patent application has been filed by the present inventors, a self-supporting ZnO single crystal can be produced by growing a thick ZnO single crystal and then removing the substrate used for the growth, but there is a problem that cracks are generated from the position at which the flux component is deposited on the Pt jig/tool used for the growth during the steps of growth, cooling and grinding/polishing.

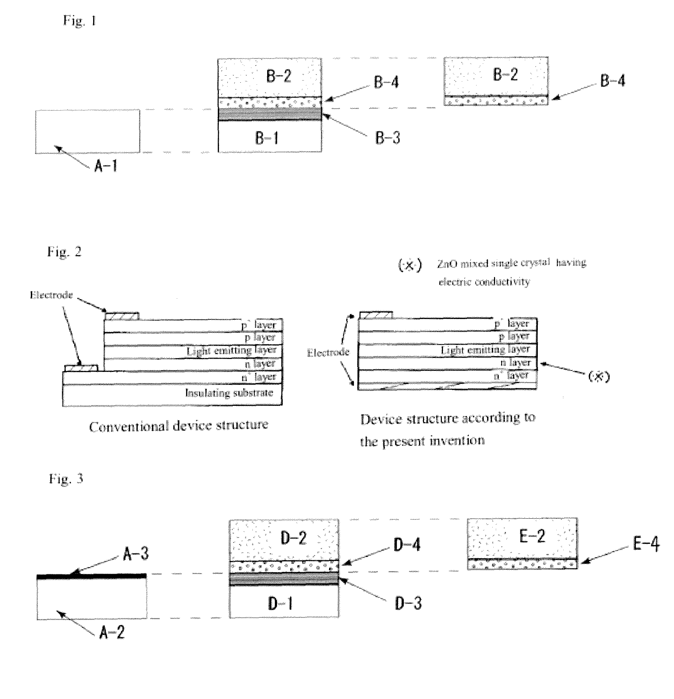

As a result of active studies on the above-described problems, the present inventors found the following causes of the problems, which will be described with reference to FIG. 1. With the conventional process, a crystal layer is grown by liquid phase epitaxy (LPE) using zinc oxide A-1 as a substrate (hereinafter, a grown layer will be occasionally referred to as the "LPE layer"). After the crystal is grown, the substrate A-1 is divided into a B-3 part in which the Li concentration in the hydrothermally synthesized substrate is decreased and a B-1 part in which the initial Li concentration is maintained. During the growth of an LPE layer B-2, Li in the hydrothermally synthesized substrate is diffused in an initially grown part and so a B-4 layer in which the Li concentration is increased is formed in the LPE-grown film. Therefore, even after B-1 and B-3 are removed, the Li-diffused layer B-4 still remains in the obtained self-supporting substrate, in addition to the LPE layer B-2 which is a target layer to be obtained. When such a self-supporting substrate is used as a substrate on which a layer is to be grown to produce an optical device or an electronic device, the device characteristics are destabilized due to the B-4 layer having a slightly higher Li concentration than that of B-2.

Between a ZnO substrate and a growing ZnO film doped with impurities, lattice mismatching is caused to a degree which is not small. In order to alleviate the distortion, a thick film needs to be grown. However, with gas phase growth, the growth rate is low and it is very difficult to grow a thick film. By contrast, with a liquid phase growth method, the growth rate can be controlled by controlling the supersaturation degree, and so a relatively high growth rate is realized.

As described above, with gas phase growth and liquid phase growth, an insulating substrate is often used as a substrate. Therefore, in order to form an electronic device or an optical device using a ZnO mixed single crystal, an arrangement such that, for example, electrodes are formed in the same direction is needed. Such an arrangement has problems, for example, that production steps of an electronic device or an optical device are complicated and so the cost is increased and also that the electric field is concentrated in a part of the n-type contact ($n^+$) layer and so the device life is shortened. However, if it is possible to grow a ZnO film having electric conductivity to be thick using an insulating substrate and to remove the insulating substrate, when becoming unnecessary, by polishing or the like, electrodes can be formed both on a front surface and a rear surface. Thus, the device is expected to have higher performance in terms of the production steps of the device, the device characteristics and the device life thereof (see FIG. 2).

In addition, the ZnO-based semiconductor single crystal and a laminate body thereof as targets of the above-mentioned study on the materials are grown by a gas phase growth method, which is a non-thermal-equilibrium growth (for example, Japanese Laid-Open Patent Publication No. 2003-046081 (Patent Document 4)). Therefore, it is unavoidable that the crystal or the laminate body is contaminated with a non-thermal-equilibrium defect, and so the crystal quality is not sufficiently high. In a field effect transistor or a pn junction light emitting device, which are examples of the conventional semiconductor devices, the crystallinity is significantly involved in the optical characteristics or semiconductor characteristics. As described above, the quality of the crystal grown by the gas phase growth method is not sufficiently high, and there is a problem that the device cannot fully exhibit the inherent performance thereof. In order to apply a ZnO-based semiconductor single crystal or a laminate body thereof for the above-mentioned uses and thus develop these devices, it is important to establish a method for producing a ZnO single crystal having high crystal quality.

As methods for growing a ZnO-based semiconductor single crystal, sputtering, CVD, PLD and the like have been conventionally used. With these methods, the growth orientation of the ZnO-based semiconductor layer is -c plane orientation. The -c plane growth has a problem that it is difficult to take in acceptors (Maki et al., Jpn. J. Appl. Phys. 42 (2003), pp. 75-77) (Non-patent Document 2). In the case of the ZnO-based semiconductor layer, it is relatively easy to realize n-type growth but it is difficult to realize p-type growth. In consideration of this, the -c plane growth has a problem of making it more difficult to realize p-type growth.

As a result of active studies, the present inventors succeeded in growing a thick Mg-containing ZnO mixed single crystal by a liquid phase epitaxial growth method by using particular compositions for the solute and the solvent. However, merely by removing the substrate after growing the mixed crystal layer, an intended light transmittance was not obtained because there was a slight bandgap difference between the front surface and the rear surface of the obtained self-supporting Mg-containing ZnO mixed single crystal.

The present inventors actively studied the above-described problems and found the following causes of the problems, which will be described again with reference to FIG. 1. With a conventional process, a mixed crystal is grown by LPE using zinc oxide A-1 as a substrate. Therefore, after the growth, Mg is diffused on the side of the hydrothermally synthesized substrate of A-1, and as a result, A-1 is divided into a B-1 part which is kept as pure zinc oxide and a B-3 part in which Mg is diffused. During the growth of a mixed crystal layer B-2, Mg is diffused to the substrate from an the initially grown part and so a B-4 part in which the Mg concentration is decreased is formed in the grown mixed crystal layer, like the diffusion layer B-3 being formed in the substrate. Therefore, even after B-1 and B-3 are removed, the diffusion layer B-4 still remains in the self-supporting Mg-containing ZnO mixed single crystal, in addition to the mixed crystal layer B-2 which is a target layer to be obtained. When such a substrate is used as a near-ultraviolet-transparent substrate to produce an optical device or an electronic device, a sufficient light transmittance cannot be obtained due to B-4 having a slightly narrower bandgap than that of B-2. In addition, in the hydrothermally synthesized substrate used for the LPE growth, Li is contained as an impurity as described above. Especially on the surface of the substrate, a Li impurity-concentrated layer is formed. Therefore, a Li-diffused layer is formed in the B-4 layer, and so the composition is non-uniform.

As a substrate on which a ZnO-based LED is to be grown, a substrate which is lattice-matched with ZnO to be grown and is transparent to light from the LED is optimal in terms of light take-out efficiency. For realizing this, it is preferable to use a self-supporting Mg-containing ZnO mixed single crystal formed only of a Mg-containing ZnO mixed single crystal and having a wider bandgap than that of ZnO.

As methods for growing a ZnO mixed single crystal and a laminate body thereof, sputtering, CVD, PLD and the like have been conventionally used. With these methods, the growth orientation of the ZnO-based semiconductor layer is -c plane orientation. However, the -c plane growth has a problem that it is difficult to take in acceptors (Maki et al., Jpn. J. Appl. Phys. 42 (2003), pp. 75-77) (Non-patent Document 2). In the case of the ZnO mixed crystal layer, it is easy to realize n-type growth but it is difficult to realize p-type growth. In consideration of this, the -c plane growth has a problem of making it more difficult to realize p-type growth. Also, there are other problems that because the film grown on the -c plane has an oxygen surface, the rate of etching by acid is high and so is difficult to control, and that it is difficult to provide etching with a high level of flatness.

Meanwhile, transparent electronic devices mainly using oxide semiconductors have been studied. When p-Si is used, the bandgap is narrow and generation of photocarriers caused by light irradiation causes malfunction. Therefore, a TFT using p-Si needs to include a metal mask for shielding light. Therefore, the TFT using p-Si cannot have a sufficient light transmittance. By contrast, a TFT using a semiconductor which does not absorb visible light is expected to operate normally without being influenced by light. Currently, TFTs for liquid crystal panels use p-Si, and the ratio of the light-transmissive area is about 50% due to the presence of the metal mask. The energy efficiency is considered to be improved by obtaining a TFT which does not need the metal mask.

Regarding a TFT using zinc oxide, it is reported that reproducibility of white color is inferior because the wavelength of the absorption edge slightly overlaps visible light. Also, there is an opinion that the mobility is inferior with polycrystalline zinc oxide.

It is known that when the Mg-containing ZnO mixed single crystal is grown at a high temperature of up to about 1000°C, the stable Mg/(Zn + Mg) ratio x which is obtainable thermodynamically is $0 < x < 0.15$ (H. Ryoken et al., Journal of Crystal Growth 287 (2006), pp. 134-138) (Non-patent Document 3).

Patent Document 1: Japanese Laid-Open Patent Publication No. 2005-72067
Patent Document 2: Japanese Laid-Open Patent Publication No. 2007-204324
Patent Document 3: Pamphlet of International Publication 2007/100146
Patent Document 4: Japanese Laid-Open Patent Publication No. 2003-046081
Non-patent Document 1: A. Ohtomo et al., Applied Physics Letters, Vol. 72, No. 19, 11 May 1998, pp. 2466-2468
Non-patent Document 2: Maki et al., Jpn. J. Appl. Phys. 42 (2003), pp. 75-77
Non-patent Document 3: H. Ryoken et al., Journal of Crystal Growth 287 (2006), pp. 134-138

DISCLOSURE OF THE INVENTION

With the ZnO hydrothermally synthesized substrate, there is the following problem: the substrate is contaminated with Li from the mineralizing agent, and when a ZnO single crystal is LPE-grown using such a substrate, Li is diffused to the LPE-grown film. There is another problem as follows: even if a thick ZnO single crystal is grown using an LPE growth method and then the substrate part is removed by polishing or etching, Li is diffused to the grown film; and so even if the LPE-grown film is put into a self-supporting state, the device characteristics are destabilized due to Li. There is still another problem as follows: when a thick ZnO single crystal is LPE-grown in order to produce a self-supporting ZnO single crystal, deposition of flux occurs from the position of the Pt jig/tool, and so cracks are likely to be generated from the position of the flux deposition during the growth, cooling and grinding/polishing.

Under such circumstances, it is desired to provide a self-supporting ZnO single crystal having a low Li concentration.

The present inventors made active studies for the purpose of obtaining a ZnO mixed single crystal which can be put into a self-supporting state, and a laminate body thereof. As a result, the present inventors found the following: mere removal of the substrate after the growth of the mixed crystal layer is not sufficient, and an intended light transmittance is not obtained because there is a slight bandgap difference between the front surface and the rear surface of the obtained self-supporting Mg-containing ZnO mixed single crystal, and moreover the impurity concentration is different between the front surface and the rear surface of the obtained self-supporting Mg-containing ZnO mixed single crystal and this may change the optical properties and electric properties. With this method, there are the following problems, which will be described with reference to FIG. 3. A mixed crystal is LPE-grown using a substrate of zinc oxide including A-3 on a surface of a high quality crystal A-2. A-3 is a contaminated layer generated by polishing or surface treatment, or is a crystallinity-deteriorated layer,. Therefore, after the growth, D-3, which is an interface of the grown layer on the side of the substrate, contains Mg diffused from the grown layer and impurities diffused from the contaminated layer. After the LPE growth, the hydrothermally synthesized substrate includes a high quality zinc oxide layer D-1 and the diffusion/contaminated layer D-3. Meanwhile, during the growth of the mixed layer, Mg is diffused from an initially grown part to the hydrothermally synthesized substrate, and impurities are diffused from the contaminated layer A-3 of the substrate. Therefore, like the diffusion layer D-3 being formed in the substrate, a diffusion layer D-4 in which the Mg concentration is decreased and the impurities are contained is formed in the grown mixed layer. Even after D-1 and D-3 are removed, a diffusion layer E-4 still remains in the self-supporting Mg-containing ZnO mixed single crystal, in addition to a mixed crystal layer E-2 which is a target layer to be obtained, in which the Li contamination level is kept at $1 \times 10^{15}$ pieces/cm$^3$ or less. The diffusion layer E-4 has a higher Li concentration than that of the E-2 layer and a lower Mg concentration than that of the E-2 layer. When such a single crystal is used as a near-ultraviolet-transparent substrate to produce a device, a sufficient light transmittance is not obtained due to the E-4 layer having a slightly narrower bandgap than that of the E-2 layer and a larger amount of Li than that of the E-2 layer.

Under such circumstances, it is desired to provide a self-supporting Mg-containing ZnO mixed single crystal having a uniform composition, with Li mixed as impurities being considered, and a laminate body thereof

The above-described problems can be solved by the present invention described below.

A first embodiment of the present invention is directed to a method for producing a ZnO single crystal using a liquid phase epitaxial growth method, the method comprising the steps of mixing and melting ZnO as a solute and a solvent, and then bringing a seed crystal substrate into direct contact with the resultant melt; and pulling up the seed crystal substrate continuously or intermittently to grow the ZnO single crystal on the seed crystal substrate. The solvent is preferably a combination of PbO and Bi$_2$O$_3$ or a combination of PbF$_2$ and PbO.

A second embodiment of the present invention is directed to a self-supporting ZnO single crystal wafer obtained by the method for producing a ZnO single crystal described above as the first embodiment, wherein the self-supporting ZnO single crystal wafer has a thickness of 100 $\mu$m or greater.

In this specification, the term "self-supporting" means being formed only of a grown layer as a result of the seed crystal substrate used for the growth being removed by polishing and/or etching. The term "continuous" means that in the step of pulling up the seed crystal substrate, the pull-up rate is constant. The term "intermittent" means that in the step of pulling up the seed crystal substrate, the pull-up rate varies. The term "solute" means a substance to be dissolved in a solvent for producing a solution. The term "solvent" means a substance acting as a medium of the substance to be dissolved for producing a solution.

A third embodiment of the present invention is directed to a self-supporting Mg-containing ZnO mixed single crystal wafer, which has a plate-like shape having a thickness of 50 $\mu$m or greater and has a chemical composition of Zn and Mg that is uniform in a thickness direction and a planar direction of the plate, and in which at least one of a front surface and a rear surface thereof is sufficiently flat to allow epitaxial growth to be made thereon.

A fourth embodiment of the present invention is directed to a method for producing a Mg-containing ZnO mixed single crystal using a liquid phase epitaxial growth method, the method comprising the steps of mixing and melting ZnO and MgO forming a solute and a solvent, and then bringing a seed crystal substrate into direct contact with the resultant melt; and pulling up the seed crystal substrate continuously or intermittently to grow the Mg-containing ZnO mixed single crystal on the seed crystal substrate. The solvent is preferably a combination of PbO and Bi$_2$O$_3$ or a combination of PbF$_2$ and PbO.

A fifth embodiment of the present invention is directed to a self-supporting Mg-containing ZnO mixed single crystal wafer produced by the method for producing a Mg-containing ZnO mixed single crystal described above as the fourth embodiment, wherein the self-supporting Mg-containing ZnO mixed single crystal wafer has a plate-like shape having a thickness of 50 $\mu$m or greater and has a chemical composition of Zn and Mg which is uniform in a thickness direction and a planar direction of the plate, and at least one of a front surface and a rear surface thereof is sufficiently flat to allow epitaxial growth to be made thereon.

In this specification, the term "Mg-containing ZnO mixed single crystal" means a single crystal having a composition of Zn$_{1-x}$Mg$_x$O ($0 < x < 0.15$).

According to a preferable embodiment of the present invention, a thick ZnO single crystal can be obtained. A self-supporting ZnO single crystal having a low Li concentration is obtained by, after the ZnO single crystal is grown, removing the seed crystal substrate by polishing or etching, and polishing or etching a surface, on the side of -c plane, of the single crystal grown by the liquid phase epitaxial growth method. The obtained self-supporting ZnO single crystal is preferably usable as a wafer as it is or as a seed crystal substrate of a ZnO mixed single crystal.

A self-supporting ZnO single crystal wafer in a preferable embodiment of the present invention has a high crystallinity and allows the carrier concentration to be controlled while the carrier mobility is kept high. In addition, the Li diffusion from the substrate can be reduced, and so the instable operation when the device is started can be suppressed. Moreover, because the ZnO single crystal wafer is self-supporting, both of the +c plane and the -c plane can be used as a substrate on which a device is to be formed. Thus, a plane for growth preferable to the intended device can be chosen.

According to a preferable embodiment of the present invention, a self-supporting Mg-containing ZnO mixed single crystal having a wider bandgap than that of ZnO and having transparency to light in the range from visible light to ultraviolet light is obtained. The obtained self-supporting Mg-containing ZnO mixed single crystal is a single crystal and so can realize a high mobility, which is not obtained with a polycrystal, and is preferably usable as a wafer or the like.

A self-supporting Mg-containing ZnO mixed single crystal wafer in a preferable embodiment of the present invention has a high crystallinity and allows the carrier concentration to be controlled while the carrier mobility is kept high. In addition, because a layer in which the composition is not uniform is removed, the composition of Zn and Mg is uniform, which increases the transmittance in the near ultraviolet range. Therefore, the light take-out efficiency of a light emitting device, using ZnO, such as an LED can be increased. Moreover, the Li diffusion from the substrate can be reduced, and so the instable operation when the device is started can be suppressed. By containing at least one selected from the group consisting of Al, Ga, In, H and F, the wafer can have electric conductivity. Since the Mg-containing ZnO mixed single crystal wafer is self-supporting both of the +c plane and the -c plane can be used as a substrate on which a device is to be formed. Thus, a plane for the growth preferable to the intended device can be chosen. Owing to the above-described characteristics, the Mg-containing ZnO mixed single crystal wafer can be used for a TFT transparent to visible light. A self-supporting Mg-containing ZnO mixed single crystal wafer according to the present invention is usable for electronic devices and optical devices which are expected to be developed in the future.

BRIEF DESCRIPTION OF THE DRAWINGS

FIG. 1 is a schematic cross-sectional view for explaining the problems regarding the production of a self-supporting Mg-containing ZnO mixed single crystal.

FIG. 2 is a structural view showing a conventional device structure and a device structure using a self-supporting Mg-containing ZnO mixed single crystal obtained by the present invention.

FIG. 3 is a schematic cross-sectional view for explaining the problems regarding the production of a self-supporting Mg-containing ZnO mixed single crystal.

FIG. 4 is a structural view of a hearth used in examples of the present invention and comparative examples.

DESCRIPTION OF THE REFERENCE NUMERALS

1:   Top heater
2:   Middle heater
3:   Bottom heater
4:   Pt crucible
5:   Pull-up shaft
6:   Substrate holder
7:   Substrate
8:   Melt
9:   Crucible table
10:   Thermocouple
11:   Core pipe
12:   Core lid

BEST MODE FOR CARRYING OUT THE INVENTION

Hereinafter, the present invention will be described in detail.
A first embodiment of the present invention is directed to a method for producing a ZnO single crystal using a liquid phase epitaxial growth method, the method comprising the steps of mixing and melting ZnO as a solute and a solvent, and then bringing a seed crystal substrate into direct contact with the resultant melt; and pulling up the seed crystal substrate continuously or intermittently to grow the ZnO single crystal on the seed crystal substrate.

In order to produce a self-supporting ZnO single crystal, a thick ZnO single crystal needs to be grown. In order to be usable to produce a device, the produced ZnO single crystal needs to have a thickness at which cracks or the like are not generated. Such a thickness is at least about 50 $\mu$m. In order to allow the self-supporting ZnO single crystal, obtained after the seed crystal substrate is polished, to have a thickness of 50 $\mu$m, the thickness of the grown film needs to be about 100 $\mu$m or greater in consideration of the thickness polished away from the front surface and the rear surface of the grown film. Using the method according to the "method for producing ZnO single crystal by a liquid phase growth method" (Pamphlet of International Publication 2007/100146), a patent application for which has been already filed by the present inventors, a ZnO single crystal having a thickness of 100 $\mu$m or greater can be grown. According to this method, the hydrothermally synthesized substrate is held by a Pt jig/tool, and a surface of the substrate is brought into contact with a surface of the melt, thus to cause epitaxial growth. However, it was found that because the Pt jig/tool has a high thermal conductivity, the temperature of an area around the Pt jib is lowered and as a result, deposition of flux is likely to occur in the vicinity of the Pt jig/tool. It was also found that when the deposition of flux occurs, the flux component is taken into the grown film, and cracks are generated from the position of the flux component during the growth, cooling and grinding/polishing, which lowers the yield.

As a result of conducting active studies in order to solve this problem, the present inventors found the following: by pulling up the Pt jig/tool holding the seed crystal substrate continuously or intermittently during the growth and thus shortening the time duration in which the Pt jig/tool is in contact with the melt, the contamination of the film with flux can be reduced, and as a result, crack generation during the growth and polishing/etching can be suppressed. As a technique for pulling up the shaft, both of continuous pull-up and intermittent pull-up are usable, but continuous pull-up is superior to realize stable growth.

A rate V at which the seed crystal substrate is continuously pulled up is preferably 2 $\mu$m/hr or greater and 50 $\mu$m/hr or less. The rate V is more preferably 4 $\mu$m/hr or greater and 20 $\mu$m/hr or less, and still more preferably 6 $\mu$m/hr or greater and 10 $\mu$m/hr or less. When the rate V is less than 2 $\mu$m/hr, the effect of reducing the contamination with flux by pulling up the shaft is small; and when the rate V exceeds 50 $\mu$m/hr, the substrate may possibly be away from the surface of the melt. When the seed crystal substrate is pulled up intermittently, it is preferable that the average rate is in the above-described range. Namely, the average rate v at which the seed crystal substrate is pulled up intermittently is preferably 2 $\mu$m/hr or greater and 50 $\mu$m/hr or less, more preferably 4 $\mu$m/hr or greater and 20 $\mu$m/hr or less, and still more preferably 6 $\mu$m/hr or greater and 10 $\mu$m/hr or less.

There is no specific limitation on the usable solvent as long as the solvent can melt ZnO as a solute. A combination of PbO and $Bi_2O_3$ and a combination of $PbF_2$ and PbO are preferable. Regarding the mixing ratio of the solute and the solvent, it is preferable that solute as entirely converted to ZnO:solvent = 5 to 30 mol%:95 to 70 mol%. More preferably, the concentration of the solute is 5 mol% or greater and 10 mol% or less. When the concentration of the solute is less than 5 mol%, the growth rate is too low; and when the concentration of the solute exceeds 10 mol%, the growth temperature is too high and so the vaporizing amount of the solute may be excessive.

A preferable embodiment of the present invention is directed to a method for producing a ZnO single crystal using a liquid phase epitaxial growth method, the method comprising the steps of mixing and melting ZnO as a solute, and PbO and $Bi_2O_3$ forming a solvent, and then bringing a seed crystal substrate into direct contact with the resultant melt; and pulling up the seed crystal substrate continuously or intermittently to grow the ZnO single crystal on the seed crystal substrate. In a preferable embodiment of the present invention, the mixing ratio of the solute, and PbO and $Bi_2O_3$ forming the solvent, is solute:solvent = 5 to 30 mod%:95 to 70 mol%, and the mixing ratio of PbO and $Bi_2O_3$ forming the solvent is PbO:$Bi_2O_3$ = 0.1 to 95 mol%:99.9 to 5 mol%. The solvent composition is more preferably PbO:$Bi_2O_3$ = 30 to 90 mol°%:70 to 10 mol%, and especially preferably PbO:$Bi_2O_3$ = 60 to 80 mol%:40 to 20 mol%. When PbO or $Bi_2O_3$ is used independently, the liquid phase growth temperature is too high, and so a mixed solvent of PbO and $Bi_2O_3$ having the above-mentioned ratio is preferable. Regarding the mixing ratio of ZnO as the solute, and PbO and $Bi_2O_3$ forming as the solvent, the concentration of the solute is more preferably 5 mol% or greater and 10 mol% or less. When the concentration of the solute is less than 5 mol%, the growth rate is too low; and when the concentration of the solute exceeds 10 mol%, the growth temperature may be too high.

A preferable embodiment of the present invention is directed to a method for producing a ZnO single crystal using a liquid phase epitaxial growth method, the method comprising the steps of mixing and melting ZnO as a solute, and $PbF_2$ and PbO forming a solvent, and then bringing a seed crystal substrate into direct contact with the resultant melt; and pulling up the seed crystal substrate continuously or intermittently to grow the ZnO single crystal on the seed crystal substrate. In a preferable embodiment of the present invention, the mixing ratio of ZnO as the solute, and $PbF_2$ and PbO forming the solvent, is solute:solvent = 2 to 20 mol%:98 to 80 mol%, and the mixing ratio of $PbF_2$ and PbO forming the solvent is $PbF_2$:PbO = 80 to 20 mol%:20 to 80 mol%. When the solvent mixing ratio is $PbF_2$:PbO = 80 to 20 mol%:20 to 80 mol%, the vaporizing amount of $PbF_2$ and PbO forming the solvent can be suppressed low. As a result, the change of the concentration of the solute is reduced, and so the ZnO single crystal can be grown stably. The mixing ratio of $PbF_2$ and PbO forming the solvent is more preferably $PbF_2$:PbO = 60 to 40 mol%:40 to 60 mol%. Regarding the mixing ratio of ZnO as the solute, and $PbF_2$ and PbO forming the solvent, it is more preferable that the concentration of the solute is 5 to 10 mol%. When the concentration of the solute is less than 5 mol%, the growth rate is too low; and when the concentration of the solute exceeds 10 mol%, the temperature for dissolving the solute component is too high and so the vaporizing amount of the solvent may be excessive. According to the present invention, a liquid phase growth method is used. Unlike a gas phase growth method, the liquid phase growth method does not require a vacuum system and so can produce a ZnO single crystal at low cost. In addition, this method provides heat equilibrium growth, and so a ZnO single crystal having a high crystallinity can be grown. The growth rate can be controlled by controlling the supersaturation degree, and so a relatively high growth rate is realized.

In a preferable embodiment of the present invention, the ZnO single crystal contains a small amount of different element. ZnO can express or change the characteristics thereof by being doped with a different element. In a preferable embodiment of the present invention, at least one selected from the group consisting of Li, Na, K, Cs, Rb, Be, Ca, Sr, Ba, Cu, Ag, N, P, As, Sb, Bi, B, Tl, Cl, Br, I, Mn, Fe, Co, Ni, Cd, Ti, Zr, Hf, V, Nb, Ta, Cr, Mo, W, lanthanoid elements and the like is added. The amount to be added is 20 mol% or less, preferably 10 mol% or less, and more preferably 1 mol% or less, with respect to ZnO used as the solute. By containing a different element, the ZnO single crystal can be made applicable for p-type semiconductors, n-type semiconductors, magnetic semiconductors, conductivity control, varistors, piezoelectric devices, electric field light emitting devices, transparent TFTs and the like.

In a preferable embodiment of the present invention, a ZnO single crystal is used as a seed crystal substrate on which the crystal is to be grown. For the substrate on which the ZnO single crystal is to be grown, any material which has the same type of crystalline structure as that of ZnO and does not react with the growing thin film is usable. Usable materials include, for example, sapphire, $LiGaO_2$, $LiAlO_2$, $LibO_3$, $LiTaO_3$, $ScAlMgO_4$, GaN, ZnO and the like. Considering that the target single crystal of the present invention is a ZnO single crystal, homoepitaxial growth using a ZnO substrate which is highly lattice-matched with the growing crystal is preferable in terms of crystallinity, reduction of distortion, reduction of warp of the growing film, and reduction of the amount of impurities diffused from the substrate.

In a preferable embodiment of the present invention, the growth orientation of the ZnO single crystal is +c plane. In a preferable embodiment of the present invention, after the ZnO single crystal is grown on the seed crystal substrate, the ZnO single crystal can be put into a self-supporting state by removing the seed crystal substrate used for the growth by polishing or etching. In this step, a laver of Li diffused from the substrate can be removed by removing the seed crystal substrate at the -c plane on the side of the substrate used for the growth by at least 10 $\mu$m, preferably 20 $\mu$m or greater. As a method for removing the substrate, both of polishing and etching is usable. A grinding and polishing method, by which the thickness of the film is easy to control, is preferable. On the hydrothermally synthesized substrate, the ZnO single crystal is grown. In order to allow the ZnO single crystal to have a thickness of about 50 $\mu$m after being polished or etched, the thickness of the grown film needs to be about 100 $\mu$m. After the growth, the ZnO single crystal is fixed on a ceramic plate at a surface on the side of the substrate with wax, and the liquid phase epitaxial growth surface can be flattened by a grinder. The ZnO single crystal is then fixed to the ceramic plate at the LPE surface (+c plane) and a thickness corresponding to the thickness of the substrate is removed by grinding, thus to leave only the film grown by liquid phase epitaxy. The front surface and the rear surface thereof may be wrapped and polished. In this step, the layer containing Li diffused from the hydrothermally synthesized substrate can be removed by polishing the surface of the LPE-grown film on the side of the hydrothermally synthesized substrate by preferably 10 $\mu$m and more preferably 20 $\mu$m or greater.

In a preferable embodiment of the present invention, the ZnO single crystal is caused to contain at least one selected from the group consisting of Al, Ga, In, H and F. By containing at least one selected from the group consisting of Al, Ga, In, H and F, the ZnO single crystal can express the electric conductivity. By removing the substrate used for the growth by polishing, etching or the like, the ZnO single crystal becomes a conductive self-supporting substrate. Such a conductive self-supporting substrate is usable for an electronic device or an optical device and allows electrodes to be formed on a front surface and a rear surface thereof

A second embodiment of the present invention is directed to a self-supporting ZnO single crystal wafer obtained by the method for producing a ZnO single crystal described above in the first embodiment of the present invention, wherein the self-supporting ZnO single crystal wafer has a thickness of 100 $\mu$m or greater. When the thickness is less than 100 $\mu$m, a thickness of 50 $\mu$m is not obtained after the substrate is polished, and so it is difficult to use the produced wafer to produce a device. The upper limit of the thickness is not defined, but when the thickness exceeds 500 $\mu$m, the growth time is too long.

In a preferable embodiment of the present invention, the Li concentration of the self-supporting ZnO single crystal wafer, obtained by the method for producing a ZnO single crystal according to the first embodiment, is uniform in a planar direction and a thickness direction of the wafer, and is preferably $1 \times 10^{15}$ pieces/cm$^3$ or less and more preferably $1 \times 10^{14}$ pieces/cm$^3$ Herein, the expression that "the Li concentration is $1 \times 10^{15}$ pieces/cm$^3$ or less and is uniform" means that the concentration of Li which destabilizes the device operation is $1 \times 10^{15}$ pieces/cm$^3$ or less in the entire self-supporting film. The uniformity of the Li concentration can be obtained as follows. After the ZnO single crystal is processed into a self-supporting state, the Li concentration at several points on the front surface and the rear surface of the ZnO single crystal are measured by dynamic SIMS, and thus the uniformity of the planar Li concentration in the front surface and the rear surface can be determined. Moreover, the sample, on which the uniformity of the planar Li concentration in the front surface and the rear surface has been determined, is cut vertically to the c plane and the Li concentration of the resultant cross-section is measured by dynamic SIMS, and thus the uniformity of the Li concentration in the thickness direction can be determined.

In a preferable embodiment of the present invention, regarding the flatness, it is acceptable if the flatness of at least one of the front surface and the rear surface of the self-supporting ZnO single crystal wafer is of a level at which epitaxial growth is possible. For example, at an optimal position of the ZnO single crystal wafer, the surface roughness Ra of an area enclosed by four 50 $\mu$m-long sides is preferably 0.5 nm or less, and more preferably 0.3 nm or less. A surface roughness Ra exceeding 0.5 nm is not preferable because with such a level of surface roughness Ra, the LED growing film grows three-dimensionally or pit defects tend to be increased. By contrast, the levels of flatness of the front surface and the rear surface are preferably as close as possible to each other. When the flatness is different between the front surface and the rear surface, warp is caused. The surface roughness Ra can be measured on an area enclosed by four 50 $\mu$m-long sides in a central part of the self-supporting film using atomic force microscopy (AFM).

In a preferable embodiment of the present invention, the self-supporting ZnO single crystal wafer contains Ga. The carrier concentration is $2.0 \times 10^{17}$ pieces/cm$^3$ to $1.0 \times 10^{19}$ pieces/cm$^3$. The Li concentration is preferably $1 \times 10^{15}$ pieces/cm$^3$ or less, and more preferably $1 \times 10^{14}$ pieces/cm$^3$ or less.

In another preferable embodiment of the present invention, the self-supporting ZnO single crystal wafer contains Al. The carrier concentration is $2.0 \times 10^{17}$ pieces/cm$^3$ to $1.0 \times 10$ pieces/cm$^3$. The Li concentration is preferably $1 \times 10^{15}$ pieces/cm$^3$ or less, and more preferably $1 \times 10^{14}$ pieces/cm$^3$ or less.

In still another preferable embodiment of the present invention, the self-supporting ZnO single crystal wafer contains In. The carrier concentration is $2.0 \times 10^{17}$ pieces/cm$^3$ to $3.5 \times 10^{17}$ pieces/cm$^3$. The Li concentration is preferably $1 \times 10^{15}$ pieces/cm$^3$ or less, and more preferably $1 \times 10^{14}$ pieces/cm$^3$ or less.

In this specification, the "carrier concentration" and the "carrier mobility" can be measured at room temperature by a Van Der Pauw method using a hole effect/specific resistance measuring device produced by Toyo Corporation.

A third embodiment of the present invention is directed to a self-supporting Mg-containing ZnO mixed single crystal wafer, which has a plate-like shape having a thickness of 50 $\mu$m or greater and has a chemical composition of Zn and Mg which is uniform in a thickness direction and a planar direction of the plate, and in which at least one of a front surface and a rear surface thereof is sufficiently flat to be usable as a substrate for epitaxial growth. A thickness of less than 50 $\mu$m is not preferable because it is difficult to handle such a thin substrate. The upper limit of the thickness is not specifically defined, but when the thickness exceeds 500 $\mu$m, the growth time is too long. Regarding the self-supporting Mg-containing ZnO mixed single crystal wafer, the composition uniformity in the thickness direction and the planar direction is preferably within $\pm 10\%$ and more preferably $\pm 5\%$. A composition uniformity exceeding $\pm 10\%$ is not preferable because with such a level of composition uniformity, the transmittance in the near ultraviolet range is reduced. In the present invention, the composition uniformity in the planar direction is evaluated by the uniformity of the Mg/(Zn + Mg) composition on the front surface and the rear surface of the self-supporting Mg-containing ZnO mixed single crystal wafer, and can be found by measuring the PL-emitted wavelength distribution in the front surface and the rear surface of the self-supporting Mg-containing ZnO mixed single crystal wafer.

The composition uniformity in the thickness direction is evaluated by the uniformity of the Mg/(Zn + Mg) composition in the thickness direction of the self-supporting Mg-containing ZnO mixed single crystal wafer, and can be found as follows: the sample, on which the PL-emitted wavelength distribution in the front surface and the rear surface has been measured, is cut vertically to the c plane, and the CL (cathode luminescence; electron beam-excited light emission spectrum measurement)-emitted wavelength distribution of the resultant cross-section is measured.

Regarding the flatness, it is acceptable if the flatness of at least one of the front surface and the rear surface of the self-supporting Mg-containing ZnO mixed single crystal wafer is of a level at which epitaxial growth is possible. For example, at an optimal position of the self-supporting Mg-containing ZnO mixed single crystal wafer, the surface roughness Ra of an area enclosed by four 50 $\mu$m-long sides is preferably 0.5 nm or less, and more preferably 0.3 nm or less. A surface roughness Ra exceeding 0.5 nm is not preferable because with such a level of surface roughness Ra, the LED growing film grows three-dimensionally or pit defects tend to be increased. By contrast, the levels of flatness of the front surface and the rear surface are preferably as close as possible to each other. When the flatness is different between the front surface and the rear surface, warp is caused. The surface roughness Ra can be measured on an area enclosed by four 50 $\mu$m-long sides in a central part of the self-supporting film using atomic force microscopy (AFM).

A preferable embodiment of the present invention is directed to a self-supporting Mg-containing ZnO mixed single crystal wafer in which the bandgap (Eg) value is uniform in a planar direction and a thickness direction of the wafer, and exceeds 3.30 eV. Herein, the uniformity of the bandgap (Eg) value can be found from the PL- and CL-emitted wavelengths. The bandgap (Eg) value is preferably within $\pm 6\%$ and more preferably $\pm 3\%$.

The bandgap of a ZnO mixed single crystal can be controlled by mixing ZnO and MgO or BeO. Considering toxicity and the like, it is preferable to mix ZnO and MgO. A bandgap of the ZnO mixed single crystal of less than 3.30 eV is not preferable because with such a level of bandgap, the mixing ratio of MgO is too low.

The bandgap (Eg) can be found by measuring the PL- and CL-emitted wavelengths of the Mg-containing ZnO mixed single crystal obtained by the present invention and using the following expression.

$$\text{Eg [eV]} = 1.24/\text{PL (CL)-emitted wavelength [nm]} * 1000$$

There is no specific limitation on the method for measuring the PL-emitted wavelength. In the present invention, the measurement is done at room temperature (300K) using rpm 2000 produced by Accent and using He-Cd laser ($\lambda$ = 325 mm) as an excitation laser.

There is no specific limitation on the method for measuring the CL-emitted wavelength. In the present invention, the measurement is done at room temperature using an electron beam of 5 KeV as an excitation source.

In a preferable embodiment of the present invention, the self-supporting Mg-containing ZnO mixed single crystal wafer contains at least one selected from the group consisting of Al, Ga, In, H and F. By containing at least one selected from the group consisting of Al, Ga, In, H and F, the self-supporting Mg-containing ZnO mixed single crystal can express the electric conductivity. After the substrate used for the growth is removed by polishing, etching or the like, the resultant conductive self-supporting crystal is usable for an electronic device or an optical device and allows electrodes to be formed on a front surface and a rear surface thereof Thus, a conductive self-supporting Mg-containing ZnO mixed single crystal can be provided. Such a conductive self-supporting Mg-containing ZnO mixed single crystal is usable in a ZnO-LED device as an LED-light-transparent, lattice-matched and conductive substrate.

A preferable embodiment of the present invention is directed to a self-supporting Mg-containing ZnO mixed single crystal wafer in which the Li concentration is uniform in a planar direction and a thickness direction of the wafer, and is preferably $1 \times 10^{15}$ pieces/cm$^3$ or less and more preferably $1 \times 10^{14}$ pieces/cm$^3$. Herein, the expression that "the Li concentration is $1 \times 10^{15}$ pieces/cm$^3$ or less and is uniform" means that the concentration of Li which destabilizes the device operation is $1 \times 10^{15}$ pieces/cm$^3$ or less in the entire self-supporting film.

The uniformity of the Li concentration can be obtained as follows. After the Mg-containing ZnO mixed single crystal is processed into a self-supporting state, the Li concentration at several points on the front surface and the rear surface of the Mg-containing ZnO mixed single crystal are measured by dynamic SIMS, and thus the uniformity of the planar Li concentration in the front surface and the rear surface can be determined. Moreover, the sample, on which the uniformity of the planar Li concentration in the front surface and the rear surface has been determined, is cut vertically to the c plane and the Li concentration of the resultant cross-section is measured by dynamic SIMS, and thus the uniformity of the Li concentration in the thickness direction can be determined. In this specification, the dynamic SIMS analysis is performed using a device produced by Cameca under the following conditions: primary ion species: O$^{2+}$; primary ion acceleration voltage: 8 KeV; and measurement temperature: room temperature.

The hydrothermally synthesized substrate used for the liquid phase epitaxial growth contains Li of about $1 \times 10^{15}$ pieces/cm$^3$ to $1 \times 10^{17}$ pieces/cm$^3$. As of the application filing date of the present invention, in order to grow a crystal having a high crystallinity by a LPE growth method, use of a single crystal grown by hydrothermal synthesis is the only possible means. A single crystal can be grown by gas phase growth but the crystallinity of such a crystal is not necessarily high. Currently, a hydrothermally synthesized ZnO single crystal is the only functional substrate material. Therefore, it is necessary to take a measure to reduce Li impurities, which characterizes such a substrate material. If a high-quality high-purity single crystal substrate is available, it is possible to omit the step of polishing a surface of the LPE-grown film on the side of the hydrothermally synthesized substrate (on the side of the -c plane) by preferably 10 $\mu$m and more preferably 20 $\mu$m or greater. However, an area in which the Mg concentration is not uniform may be generated in an intermediate layer between the substrate and the film due to the diffusion of Mg into the substrate. Therefore, even if a high-quality high-purity single crystal substrate is available, it is still preferable to polish the surface of the LPE-grown film on the side of the hydrothermally synthesized substrate (on the side of the -c plane) by preferably 10 $\mu$m and more preferably 20 $\mu$m or greater. As described above, when liquid phase epitaxial growth is performed using the hydrothermally synthesized substrate, Li is diffused from the hydrothermally synthesized substrate, and thus the device operation is destabilized. With liquid phase epitaxial growth, the material contains almost no Li and so the grown film is unlikely to be contaminated with Li. However, thermal diffusion of Li may occur from the Li-concentrated layer in the substrate or on the surface of the substrate. As a result of active studies, the present inventors found that the Li concentration in the film grown by liquid phase epitaxy can be made $1 \times 10^{15}$ pieces/cm$^3$ or less by polishing the rear surface of the LPE-grown film which is on the side of the hydrothermally synthesized substrate (-c plane) by preferably 10 μm and more preferably 20 μm or greater. By using the film obtained in this manner for a Mg-containing ZnO mixed single crystal wafer, the destabilization of the device operation due to the Li can be suppressed.

A fourth embodiment of the present invention is directed to a method for producing a Mg-containing ZnO mixed single crystal using a liquid phase epitaxial growth method, the method comprising the steps of mixing and melting ZnO and MgO forming a solute and a solvent, and then bringing a seed crystal substrate into direct contact with the resultant melt; and pulling up the seed crystal substrate continuously or intermittently to grow the Mg-containing ZnO mixed single crystal on the seed crystal substrate.

In order to produce a self-supporting Mg-containing ZnO mixed single crystal, a thick Mg-containing ZnO mixed single crystal needs to be grown. In order to allow the self-supporting Mg-containing ZnO mixed single crystal, obtained after being polished, to have a thickness of 50 μm, the thickness of the grown film needs to be about 100 μm or greater in consideration of the thickness polished away from the front surface and the rear surface of the grown film. The present inventors found that a Mg-containing ZnO mixed single crystal having a thickness of 100 μm or greater can be grown using a liquid phase epitaxial growth method by the following process. After ZnO and MgO forming a solute and PbO and Bi$_2$O$_3$ forming a solvent are mixed and melted, the obtained melt is brought into direct contact with a seed crystal or a substrate, and the growth time or the temperature fall rate during the growth is appropriately adjusted; or after ZnO and MgO forming a solute and PbF$_2$ and PbO forming a solvent are mixed and melted, the obtained melt is brought into direct contact with a seed crystal or a substrate, and the growth time or the temperature fall rate during the growth is appropriately adjusted. With this process, the hydrothermally synthesized substrate is held by a Pt jig/tool, and a surface of the substrate is brought into contact with a surface of the melt, thus to cause epitaxial growth. However, it was found that because the Pt jig/tool has a high thermal conductivity, deposition of flux is likely to occur in the vicinity of the Pt jig/tool. It was also found that when the deposition of flux occurs, the flux component is taken into the grown film, and cracks are generated from the position of the flux component during the growth, cooling and grinding/polishing, which lowers the yield.

As a result of conducting active studies in order to solve this problem, the present inventors found the following: by pulling up the Pt jig/tool holding the substrate continuously or intermittently during the growth and thus shortening the time duration in which the Pt jig/tool is in contact with the melt, the contamination of the film with flux can be reduced, and as a result, crack generation during the growth and polishing/etching can be suppressed. As a technique for pulling up the shaft, both of continuous pull-up and intermittent pull-up are usable, but continuous pull-up is superior to realize stable growth.

A rate V at which the seed crystal substrate is continuously pulled up is preferably 2 μm/hr or greater and 50 μm/hr or less. The rate V is more preferably 4 μm/hr or greater and 20 μm/hr or less, and still more preferably 6 μm/hr or greater and 10 μm/hr or less. When the rate V is less than 2 μm/hr, the effect of reducing the contamination with flux by pulling up the shaft is small; and when the rate V exceeds 50 μm/hr, the substrate may possibly be away from the surface of the melt. When the seed crystal substrate is pulled up intermittently, it is preferable that the average rate is in the above-described range. Namely, the average rate v at which the seed crystal substrate is pulled up intermittently is preferably 2 μm/hr or greater and 50 μm/hr or less, more preferably 4 μm/hr or greater and 20 μm/hr or less, and still more preferably 6 μm/hr or greater and 10 μm/hr or less.

There is no specific limitation on the usable solvent as long as the solvent can melt ZnO and MgO forming a solute. A combination of PbO and Bi$_2$O$_3$ and a combination of PbF$_2$ and PbO are preferable. Regarding the mixing ratio of the solute and the solvent, it is preferable that solute as entirely converted to ZnO:solvent = 5 to 30 mol%:95 to 70 mol%. More preferably, the concentration of the solute is 5 mol% or greater and 10 mol% or less. When the concentration of the solute is less than 5 mol%, the growth rate is too low; and when the concentration of the solute exceeds 10 mol%, the growth temperature is too high and so the vaporizing amount of the solute may be excessive.

In a preferable embodiment of the present invention, regarding the mixing ratio of the solute, and PbO and Bi$_2$O$_3$ forming the solvent, solute as entirely converted to ZnO:solvent = 5 to 30 mol%:95 to 70 mol%. The mixing ratio of PbO and Bi$_2$O$_3$ forming the solvent is PbO:Bi$_2$O$_3$ = 0.1 to 95 mol%:99.9 to 5 mol%. The solvent composition is more preferably PbO:Bi$_2$O$_3$ = 30 to 90 mol%:70 to 10 mol%, and especially preferably PbO:Bi$_2$O$_3$ = 60 to 80 mol%:40 to 20 mol%. When PbO or Bi$_2$O$_3$ is used independently, the liquid phase growth temperature is too high, and so a mixed solvent of PbO and Bi$_2$O$_3$ having the above-mentioned ratio is preferable. Regarding the mixing ratio of the solute entirely converted to ZnO, and PbO and Bi$_2$O$_3$ forming the solvent, the concentration of the solute is more preferably 5 mol% or greater and 10 mol% or less. When the concentration of the solute is less than 5 mol%, the growth rate is too low; and when the concentration of the solute exceeds 10 mol%, the growth temperature is too high and so the vaporizing amount of the solute may be excessive.

In a preferable embodiment of the present invention, regarding the mixing ratio of the solute, and PbF$_2$ and PbO forming the solvent, solute as entirely converted to ZnO:solvent = 2 to 20 mol%:98 to 80 mol%. The mixing ratio of PbF$_2$ and PbO forming the solvent is PbF$_2$:PbO = 80 to 20 mol%:20 to 80 mol%. When the solvent mixing ratio is

$PbF_2$:PbO = 80 to 20 mol%:20 to 80 mol%, the vaporizing amount of $PbF_2$ and PbO forming the solvent can be suppressed low. As a result, the change of the concentration of the solute is reduced, and so the ZnO mixed single crystal can be grown stably. The mixing ratio of $PbF_2$ and PbO forming the solvent is more preferably $PbF_2$:PbO = 60 to 40 mol%:40 to 60 mol%. Regarding the mixing ratio of ZnO and MgO forming the solute and $PbF_2$ and PbO forming the solvent, it is more preferable that the concentration of the solute as entirely converted to ZnO is 5 to 10 mol%. When the concentration of the solute is less than 5 mol%, the growth rate is too low; and when the concentration of the solute exceeds 10 mol%, the temperature for dissolving the solute component is too high and so the vaporizing amount of the solvent may be excessive. According to the present invention, a liquid phase growth method is used. Unlike a gas phase growth method, the liquid phase growth method does not require a vacuum system and so can produce a ZnO mixed single crystal at low cost. In addition, this method provides heat equilibrium growth, and so a ZnO mixed single crystal having a high crystallinity can be grown. The growth rate can be controlled by controlling the supersaturation degree, and so a relatively high growth rate is realized.

In a preferable embodiment of the present invention, the Mg-containing ZnO mixed single crystal contains a small amount of different element. ZnO can express or change the characteristics thereof by being doped with a different element. In a preferable embodiment of the present invention, at least one selected from the group consisting of Li, Na, K, Cs, Rb, Be, Ca, Sr, Ba, Cu, Ag, N, P, As, Sb, Bi, B, Tl, Cl, Br, I, Mn, Fe, Co, Ni, Cd, Ti, Zr, Hf, V, Nb, Ta, Cr, Mo, W, lanthanoid elements and the like is added. The amount to be added is 20 mol% or less, preferably 10 mol% or less, and more preferably 1 mol% or less, with respect to ZnO used as the solute. By containing a different element, the Mg-containing ZnO mixed single crystal can be made applicable for p-type semiconductors, n-type semiconductors, magnetic semiconductors, conductivity control, varistors, piezoelectric devices, electric field light emitting devices, transparent TFTs and the like.

In a preferable embodiment of the present invention, a ZnO single crystal is used as a seed crystal substrate on which the crystal is to be grown. For the substrate on which the ZnO mixed single crystal is to be grown, any material which has the same type of crystalline structure as that of ZnO and does not react with the growing thin film is usable. Usable materials include, for example, sapphire, $LiGaO_2$, $LiAlO_2$, $LiNbO_3$, $LiTaO_3$, $ScAlMgO_4$, GaN, ZnO and the like. Considering that the target single crystal of the present invention is a ZnO mixed single crystal, homoepitaxial growth using a ZnO substrate which is highly lattice-matched with the growing crystal is preferable in terms of crystallinity, reduction of distortion, reduction of warp of the growing film, and reduction of the amount of impurities diffused from the substrate.

In a preferable embodiment of the present invention, the growth orientation of the Mg-containing ZnO mixed single crystal is +c plane.

In a preferable embodiment of the present invention, after being grown on the seed crystal substrate, the Mg-containing ZnO mixed single crystal can be put into a self-supporting state by removing the seed crystal substrate used for the growth by polishing or etching. In this step, a layer in which Zn and Mg are non-uniform and a layer of Li diffused from the substrate can be removed by removing the seed crystal substrate at the - c plane on the side of the substrate used for the growth by at least 10 $\mu$m, preferably 20 $\mu$m or greater. As a method for removing the substrate, both of polishing and etching is usable. A grinding and polishing method, by which the thickness of the film is easy to control, is preferable. The Mg-containing ZnO mixed single crystal may be grown on the hydrothermally synthesized substrate. In order to allow the Mg-containing ZnO mixed single crystal to have a thickness of about 50 $\mu$m after being polished or etched, the thickness of the grown film needs to be about 100 $\mu$m. After the growth, the Mg-containing ZnO mixed single crystal is fixed on a ceramic plate at a surface on the side of the substrate with wax, and the liquid phase epitaxial growth surface can be flattened by a grinder. The Mg-containing ZnO mixed single crystal is then fixed to the ceramic plate at the LPE surface (+c plane) and a thickness corresponding to the thickness of the substrate is removed by grinding, thus to leave only the film grown by liquid phase epitaxy. At least one of the front surface and the rear surface thereof can be wrapped and polished. In this step, the layer containing Li diffused from the hydrothermally synthesized substrate can be removed by polishing the surface of the LPE-grown film on the side of the hydrothermally synthesized substrate by preferably 10 $\mu$m and more preferably 20 $\mu$m or greater.

Another embodiment of the present invention is directed to a method for producing a Mg-containing ZnO mixed single crystal laminate body, wherein after a Mg-containing ZnO mixed single crystal is grown by the above-described method for producing a Mg-containing ZnO mixed single crystal, this single crystal is used as a substrate, and a ZnO single crystal or a Mg-containing ZnO mixed single crystal is further grown on the substrate. The bandgaps of a first growth layer and a second growth layer may be optionally set. However, considering that the Mg-containing ZnO mixed single crystal is to be used for an electronic device or an optical device, it is preferable that the bandgap of the first growth layer < the bandgap of the second growth layer. As a method for growing a laminate body, LPE growth may be performed twice. For example, a plurality of melts having different compositions may be provided in the growth hearth and the growth shaft may be rotated to grow a laminate body. Alternatively, the laminate body may be grown using a sliding boat method.

In the present invention, as a method for growing a self-supporting Mg-containing ZnO mixed single crystal, a liquid phase epitaxial (LPE) method is used. With the liquid phase epitaxial method, it is easy to provide a structure including layers having different functions. A self-supporting Mg-containing ZnO mixed single crystal produced by this method is advantageous for being applied to an electronic device, an optical device and the like.

According to a fourth embodiment of the present invention, for the purpose of controlling the liquid phase growth temperature, adjusting the viscosity of the solvent and performing doping with a different element, one or at least two types of third component may be added to the solvent in a range in which the solubility of ZnO and MgO, the vaporizing amount of the solvent, preferably the vaporizing amount of PbO and $Bi_2O_3$ or the vaporizing amount of $PbF_2$ and PbO, are not significantly changed. For example, $B_2O_3$, $P_2O_5$, $V_2O_5$, $MoO_3$, $WO_3$, $SiO_2$, BaO or the like is usable as the third component. Alternatively, $Bi_2O_3$ may be added as the third component to PbO and $PbF_2$ forming the solvent. In a preferable embodiment of the present invention, a Mg-containing ZnO mixed single crystal having electric conductivity can be produced by a liquid phase epitaxial growth method by causing a Mg-containing ZnO mixed single crystal to contain at least one selected from the group consisting of Al, Ga, In, H and F.

A fifth embodiment of the present invention is directed to a self-supporting Mg-containing ZnO mixed single crystal wafer produced by the method for producing a Mg-containing ZnO mixed single crystal described above in the fourth embodiment, wherein the self-supporting Mg-containing ZnO mixed single crystal wafer has a plate-like shape having a thickness of 50 $\mu$m or greater and has a chemical composition of Zn and Mg which is uniform in a thickness direction and a planar direction, and in which at least one of a front surface and a rear surface thereof is sufficiently flat to be usable as a substrate for epitaxial growth. A thickness of less than 50 $\mu$m is not preferable because it is difficult to handle such a thin substrate. The upper limit of the thickness is not specifically defined, but when the thickness exceeds 500 $\mu$m, the growth time is too long. Regarding the self-supporting Mg-containing ZnO mixed single crystal wafer, the composition uniformity in the thickness direction and the planar direction is preferably within $\pm$10% and more preferably $\pm$5%. The composition uniformity is evaluated by the method described above. A composition uniformity exceeding $\pm$10% is not preferable because with such a level of composition uniformity, the transmittance in the near ultraviolet range is reduced. Regarding the flatness, it is acceptable if the flatness of at least one of the front surface and the rear surface of the self-supporting Mg-containing ZnO mixed single crystal wafer is of a level at which epitaxial growth is possible. For example, at an optimal position of the self-supporting Mg-containing ZnO mixed single crystal wafer, the surface roughness Ra of an area enclosed by four 50 $\mu$m-long sides is preferably 0.5 nm or less, and more preferably 0.3 nm or less. A surface roughness Ra exceeding 0.5 nm is not preferable because with such a level of surface roughness Ra, the LED growing film grows three-dimensionally or pit defects tend to be increased. By contrast, the levels of flatness of the front surface and the rear surface are preferably as close as possible to each other. When the flatness is different between the front surface and the rear surface, warp is caused.

A preferable embodiment of the present invention is directed to a self-supporting Mg-containing ZnO mixed single crystal in which the bandgap (Eg) value is uniform in a planar direction and a thickness direction of the wafer, and exceeds 3.30 eV. The uniformity of the bandgap (Eg) value can be found from the PL- and CL-emitted wavelengths as described above. When the bandgap of the ZnO mixed single crystal is less than 3.30 eV, the mixing ratio of MgO is too low.

In a preferable embodiment of the present invention, the self-supporting Mg-containing ZnO mixed single crystal wafer obtained by the method for producing a Mg-containing ZnO mixed single crystal according to the fourth embodiment contains at least one selected from the group consisting of Al, Ga, In, H and F. By containing at least one selected from the group consisting of Al, Ga, In, H and F, the self-supporting Mg-containing ZnO mixed single crystal wafer can express the electric conductivity. After the substrate used for the growth is removed by polishing, etching or the like, the resultant conductive self-supporting substrate is usable for an electronic device or an optical device and allows electrodes to be formed on a front surface and a rear surface thereof Thus, a conductive self-supporting Mg-containing ZnO mixed single crystal can be provided. Such a conductive self-supporting Mg-containing ZnO mixed single crystal is usable in a ZnO-LED device as an LED-light-transparent, lattice-matched and conductive substrate.

In a preferable embodiment of the present invention, the Li concentration of the self-supporting Mg-containing ZnO mixed single crystal wafer, obtained by the method for producing a Mg-containing ZnO mixed single crystal according to the fourth embodiment, is uniform in a planar direction and a thickness direction of the wafer, and is preferably $1 \times 10^{15}$ pieces/cm$^3$ or less and more preferably $1 \times 10^{14}$ pieces/cm$^3$. Herein, the expression that "the Li concentration is $1 \times 10^{15}$ pieces/cm$^3$ or less and is uniform" means that the concentration of Li which destabilizes the device operation is $1 \times 10^{15}$ pieces/cm$^3$ or less in the entire self-supporting film. The uniformity of the Li concentration can be obtained by the method described above.

[Examples]

Hereinafter, as processes for growing a ZnO single crystal according to one embodiment of the present invention, processes for growing a ZnO single crystal doped with a group-III element on a ZnO substrate using a liquid phase epitaxial (LPE) growth method will be described. The present invention is not limited to any of the following examples in any way.

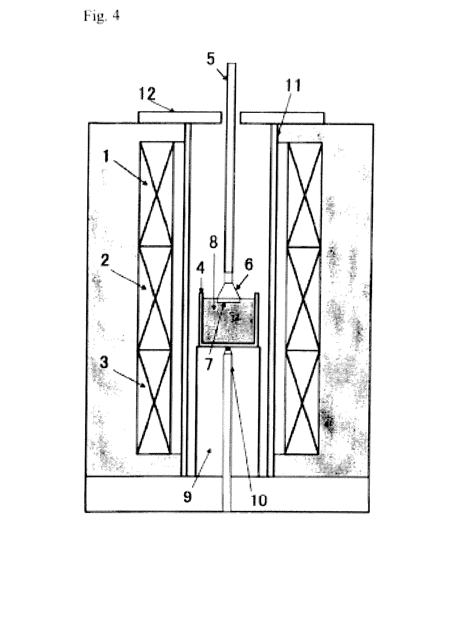

A structural view of a hearth used for the processes is shown in FIG 4.

In a single crystal production hearth, a platinum crucible 4 for melting a material and accommodating the material in a melted state as a melt is provided on a crucible table 9. Outer and lateral to the platinum crucible 4, a three-stage side heater (top heater 1, middle heater 2, and bottom heater 3) for heating and melting the material in the platinum crucible 4 is provided. An output of each heater is independently controlled, and so the amount of heat for heating the material by each heater to form the melt is independently adjusted. Between the heater and an inner wall of the production hearth, a core pipe 11 is provided. On the core pipe 11, a hearth lid 12 for opening and closing the hearth is provided. Above the platinum crucible 4, a pull-up mechanism is provided. To the pull-up mechanism, a pull-up shaft 5 is fixed. At a tip of the pull-up shaft 5, a substrate holder 6 and a substrate 7 fixed by the holder are provided. Above the pull-up shaft 5, a mechanism for rotating the pull-up shaft 5 is provided. Below the platinum crucible 4, a thermocouple 10 for managing the temperature of the crucible is provided. As a material of the growth hearth, a non-Al material is preferable. As the non-Al material, a ZnO hearth material is optimal. However, considering that no ZnO hearth material is commercially available, MgO, which does not act as a carrier even when being mixed in a ZnO thin film, is preferable. Considering a SIMS analysis result showing that even when a mullite hearth material formed of alumina and silica is used, the concentration of Si impurities in the LPE film is not increased, a quartz material is also preferable. Other usable materials include calcia, silica, $ZrO_2$, zircon ($ZrO_2$+$SiO_2$), SiC, $Si_3N_4$, and the like.

From the above, it is preferable to grow a ZnO single crystal doped with a group-III element and a Mg-containing ZnO mixed single crystal (represented with a composition of $Zn_{1-x}Mg_xO$) using a growth hearth formed using a non-Al material such as MgO and/or quartz. In addition, a growth hearth, in which a crucible table for putting a crucible thereon, a core pipe provided so as to surround an outer circumference of the crucible table, a core lid provided on the core pipe for opening and closing the hearth, and a pull-up shaft for elevating up and down a seed crystal or a substrate are independently formed of MgO or quartz, is preferably used.

In order to melt the material in the platinum crucible, the temperature of the production hearth is raised until the material is melted. Preferably, the temperature is raised to 800 to 1100°C, and then the production hearth is kept still for 2 to 3 hours to stabilize the material melt. The time duration in which the production hearth is kept still may be shortened by stirring the material melt by a Pt stirrer. In this step, the three-stage heater is offset to adjust the temperature of the bottom of the crucible to be higher by several degrees than that of a surface of the melt. The offset is preferably -100°C ≤ H1 offset ≤ 0°C and 0°C ≤ H3 offset ≤ 100°C, and more preferably -50°C ≤ H1 offset ≤ 0°C and 0°C ≤ H3 offset ≤ 50°C. The temperature of the bottom of the crucible is adjusted to be a seeding temperature of 700 to 950°C. After the temperature of the melt is stabilized, the substrate is brought into contact with the surface of the melt by elevating down the pull-up shaft while rotating the substrate at 5 to 120 rpm. After the substrate is coated with the melt to a certain degree, the temperature is kept at a fixed level or is started to be lowered at 0.01 to 3.0°C/hr, thus to grow a ZnO single crystal or a Mg-containing ZnO mixed single crystal, which is the target substance. During the growth, the substrate is rotated at 5 to 300 rpm by the rotation of the pull-up shaft, and the rotation direction is reversed every certain time. After the crystal is grown for about 30 minutes for 100 hours, the substrate is separated from the melt. The melt component is taken off by rotating the pull-up shaft at a high rate of about 200 to 300 rpm. Then, the substrate is cooled down to room temperature over 1 to 24 hours. Thus, a ZnO single crystal or a Mg-containing ZnO mixed single crystal, which is the target substance, is obtained.

(Example 1)

By the following steps, a ZnO single crystal was produced using a liquid phase epitaxial growth method. Into a platinum crucible having an inner diameter of 75 mmΦ, a height of 75 mmh and a thickness of 1 mm, ZnO, PbO and $Bi_2O_3$ as materials were put in respective amounts of 33.20 g, 829.53 g and 794.75 g. At this point, the concentration of ZnO as a solute was 7 mol%, and the concentrations of PbO and $Bi_2O_3$ forming a solvent were represented by PbO: $Bi_2O_3$ = 68.5 mol%:31.5 mol%. The crucible accommodating the materials was set in the hearth shown in FIG. 4. While the temperature of the bottom of the crucible was kept at about 840°C for 1 hour, the materials were stirred by a Pt stirring jig to be melted. Then, the temperature was lowered until the temperature of the bottom of the crucible became about 790°C. After this, a ZnO single crystal substrate grown by a hydrothermal synthesis method and having +c plane orientation and a size of 10 mm × 10 mm × 0.5 mm was used as a seed crystal and brought into contact with the melt. While the pull-up shaft was rotated at 30 rpm, the crystal was grown at the same temperature for 80 hours. The set temperatures of H1, H2 and H3 were lowered at a rate of -0.1°C/hr while the offset difference was maintained. During the LPE growth, namely, for 80 hours, the pull-up shaft was continuously pulled up by about 500 μm. The pull-up rate of the shaft in this step was about 6.3 μm/hr. In this step, the rotation direction of the shaft was reversed every 2 minutes. Then, the substrate was separated from the melt by raising the pull-up shaft, and the melt component was shaken off by rotating the shaft at 100 rpm. Then, the substrate was gradually cooled down to room temperature. Thus, a colorless and transparent ZnO single crystal was obtained. The grown film was taken out from the LPE hearth after being cooled down to room temperature, and an area around the Pt jig/tool was observed. No deposition of flux was recognized. The thickness of the LPE-grown film was 391 $\mu$m, and the growth rate of this film was about 4.9 $\mu$m/hr. Next, the following processing was performed for putting the film into a self-supporting state. A rear surface of the film (-c plane side of the hydrothermally synthesized substrate) was fixed to a ceramic plate with wax. The other surface of the LPE-grown film on the side of the +c plane was ground by about 50 $\mu$m to be flat using a horizontal plane grinder. Then, the film was turned inside out and fixed to the ceramic plate, and was ground by a thickness corresponding to the thickness of the hydrothermally synthesized substrate. Thus, a self-supporting ZnO single crystal was obtained. The thickness was about 341 $\mu$m. The self-supporting film was fixed again to the ceramic plate with wax, wrapped with diamond slurry, and polished with colloidal silica. The amount polished away from the self-supporting film was 33 $\mu$m on the +c plane and 28 $\mu$m on the -c plane. As a result, a self-supporting ZnO single crystal having a thickness of about 280 $\mu$m was obtained. During the step of grinding and polishing, cracks were not generated. After the film was processed into a self-supporting state, the $\pm$c planes were analyzed by dynamic SIMS to find the Li concentration. On both of the $\pm$c planes, the Li concentration was equal to or less than $5 \times 10^{13}$ pieces/cm$^3$, which is the lower limit for detection. In this specification, the dynamic SIMS analysis is performed using a device produced by Cameca under the following conditions: primary ion species: O$^{2+}$; primary ion acceleration voltage: 8 KeV; and measurement temperature: room temperature. The film was cut in a direction vertical to the c plane and the resultant surface was subjected to a SIMS analysis. The Li concentration was equal to or less than $5 \times 10^{13}$ pieces/cm$^3$ which is the lower limit for detection. The rocking curve half width of the (002) plane, which shows that the crystallinity of the self-supporting film, was about 33 arcsec. This indicates that the crystallinity is high. The carrier concentration, which shows the conductivity, is $2.0 \times 10^{17}$ pieces/cm$^3$, and the carrier mobility was 165 cm$^2$/V·sec. Such a high carrier mobility also shows that the quality is high. The flatness of an area enclosed by four 50 $\mu$m-long sides in a central part of the self-supporting film was evaluated by atomic force microscopy (AFM). The result was Ra = 0.3 nm.

(Examples 2-10 and Comparative example 1)

Self-supporting ZnO single crystals were obtained by substantially the same methods as in Example 1 except that Ga$_2$O$_3$ was put into the Pt crucible. In Example 10, the shaft was pulled up intermittently instead of continuously. Namely, the step of stopping the shaft and pulling up the shaft by 100 $\mu$m after 16 hours was repeated 5 times, and thus the shaft was pulled up by a total of 500 $\mu$m in 80 hours. Table 1 shows the compositions of the materials put into the crucible. Table 2 shows the physical properties of the obtained self-supporting films.

As the amount of Ga$_2$O$_3$ was increased, the carrier concentration was increased. In the case of the self-supporting film in Example 9, in which 2100 ppm of Ga$_2$O$_3$ was put with respect to ZnO, the carrier concentration was $1.0 \times 10^{19}$ pieces/cm$^3$. These results show that by putting Ga$_2$O$_3$, the carrier concentration can be controlled to be from $2.0 \times 10^{17}$ pieces/cm$^3$ to $1.0 \times 10^{19}$ pieces/cm$^3$. In Example 1 with no Ga$_2$O$_3$, the carrier mobility was 154 cm$^2$/V·sec., whereas in Example 9 with 2100 ppm of Ga$_2$O$_3$, the carrier mobility was 64 cm$^2$/V·sec. This is considered to have occurred as a result of the crystal being doped with Ga, which is a foreign substance. The rocking curve half width of the (002) plane, which shows the crystallinity, was 23 to 71 arcsec when the amount of Ga$_2$O$_3$ was 0 to 2100 ppm. This shows that the crystallinity is very high. In Examples 1 through 10, the film was polished and removed by 12 to 29 $\mu$m at the -c plane, which is the growth plane on the side of the hydrothermally synthesized substrate. As a result, the Li concentration was equal to or less than $5 \times 10^{13}$ pieces/cm$^3$, which is the lower limit for SIMS detection, on both of the $\pm$c planes.

In Comparative example 1, in which the shaft was not pulled up, deposition of flux was recognized in the vicinity of the Pt jig/tool. When the grown film was detached from the Pt jig/tool, cracks were generated from the position of the jig/tool. The biggest of the pieces of the film resulting from the cracking and having a size corresponding to 5 mm $\times$ 5 mm was processed into a self-supporting state. Regarding the physical properties, such a piece in Comparative example 1 was not much different from the film in Example 9. Comparing Examples 9 and 10 which are different from each other only in the pull-up mechanism, the crystallinity was lower and the carrier mobility was lower in Example 10 in which the shaft was pulled up intermittently. A conceivable reason for this is that because the shaft was pulled up intermittently, the LPE film was not grown stably.

The above-described results show that when the LPE growth is performed while the shaft is pulled up continuously or intermittently, the deposition of flux from the position of the Pt jig/tool is suppressed and as a result, generation of cracks during the step of growing the film or processing the film into a self-supporting state can be reduced. In the case where after the LPE growth, the substrate used for the growth is removed by polishing and the LPE-grown film is polished by at least 10 $\mu$m at the -c plane on the side of the hydrothermally synthesized substrate, the Li concentration of the LPE film can be made $1 \times 10^{15}$ pieces/cm$^3$ or less. Meanwhile, by controlling the amount of Ga$_2$O$_3$, the carrier concentration of the self-supporting ZnO single crystal wafer can be controlled to be from about $2.7 \times 10^{17}$ pieces/cm$^3$ to $1 \times 10^{19}$ pieces/cm$^3$. Therefore, when being used as a substrate of an optical element or an electronic element, this self-supporting film acts as a conductive self-supporting substrate, which is more advantageous than an insulating substrate in terms of device production cost and length of life.

Table 1

| | Amount (g) | | | | Amount (mol) | | | | Solute composition | | Solvent composition (mol%) | |
|---|---|---|---|---|---|---|---|---|---|---|---|---|
| | PbO | Bi$_2$O$_3$ | ZnO | Ga$_2$O$_3$ | PbO | Bi$_2$O$_3$ | ZnO | Ga$_2$O$_3$ | Solute concentration converted to ZnO (mol%) | Ga$_2$O$_3$*2/ ZnO+Ga$_2$O$_3$*2 (ppm) | PbO | Bi$_2$O$_3$ |
| Ex. 1 | 829.53 | 794.75 | 33.20 | 0.0000 | 3.717 | 1.706 | 0.408 | 0.00E+00 | 7.00 | 0.0 | 68.5 | 31.5 |
| Ex. 2 | 829.53 | 794.75 | 33.20 | 0.0010 | 3.717 | 1.706 | 0.408 | 5.33E-06 | 7.00 | 26 | 68.5 | 31.5 |
| Ex. 3 | 829.53 | 794.75 | 33.20 | 0.0021 | 3.717 | 1.706 | 0.408 | 1.12E-05 | 7.00 | 55 | 68.5 | 31.5 |
| Ex. 4 | 829.53 | 794.75 | 33.20 | 0.0032 | 3.717 | 1.706 | 0.408 | 1.71E-05 | 7.00 | 84 | 68.5 | 31.5 |
| Ex. 5 | 829.53 | 794.75 | 33.20 | 0.0062 | 3.717 | 1.706 | 0.408 | 3.31E-05 | 7.00 | 160 | 68.5 | 31.5 |
| Ex. 6 | 829.53 | 794.75 | 33.20 | 0.0170 | 3.717 | 1.706 | 0.408 | 9.07E-05 | 7.00 | 440 | 68.5 | 31.5 |
| Ex. 7 | 829.53 | 794.75 | 33.20 | 0.0400 | 3.717 | 1.706 | 0.408 | 2.13E-04 | 7.00 | 1000 | 68.5 | 31.5 |
| Ex. 8 | 829.53 | 794.75 | 33.20 | 0.0600 | 3.717 | 1.706 | 0.408 | 3.20E-04 | 7.00 | 1600 | 68.5 | 31.5 |
| Ex. 9 | 829.53 | 794.75 | 33.20 | 0.0800 | 3.717 | 1.706 | 0.408 | 4.27E-04 | 7.00 | 2100 | 68.5 | 31.5 |
| Ex. 10 | ↑ | ↑ | ↑ | ↑ | ↑ | ↑ | ↑ | ↑ | ↑ | ↑ | ↑ | ↑ |
| Comparative ex. 1 | ↑ | ↑ | ↑ | ↑ | ↑ | ↑ | ↑ | ↑ | ↑ | ↑ | ↑ | ↑ |

Table 2

| | Growth temper- ature | Growth time | Shaft pull-up | | | Substrate thickness | LPE film thickness | Growth rate | Crack generation | Rocking curve half width | Conductivity | | Grinding | | Polishing | | Self- suppoting film | Li concentration | |
|---|---|---|---|---|---|---|---|---|---|---|---|---|---|---|---|---|---|---|---|
| | | | System | Pull-up width | Pull-up rate | | | | | (002) plane | Carrier concentra- tion | Carrier mobility | LPE film | Substrate | +c | -c | | +c | -c |
| | °C | hr | | μm | μm/hr | μm | μm | μm/hr | | arcsec | pieces/cm³ | cm²/Vs | μm | μm | μm | μm | μm | pieces/cm³ | |
| Ex. 1 | 790 | 80 | Continuous | 500 | 6.3 | 538 | 391 | 4.9 | Not occur | 33 | 2.0E+17 | 154 | 50 | 538 | 33 | 28 | 280 | <5e13 | <5e13 |
| Ex. 2 | 789 | 80 | Continuous | 500 | 6.3 | 537 | 410 | 5.1 | Not occur | 28 | 4.0E+17 | 131 | 50 | 537 | 30 | 14 | 316 | <5e13 | <5e13 |
| Ex. 3 | 786 | 80 | Continuous | 500 | 6.3 | 520 | 417 | 5.2 | Not occur | 46 | 1.2E+18 | 93 | 50 | 520 | 22 | 24 | 321 | <5e13 | <5e13 |
| Ex. 4 | 783 | 80 | Continuous | 500 | 6.3 | 519 | 320 | 4.0 | Not occur | 71 | 1.5E+18 | 89 | 50 | 519 | 25 | 23 | 222 | <5e13 | <5e13 |
| Ex. 5 | 784 | 80 | Continuous | 500 | 6.3 | 521 | 389 | 4.9 | Not occur | 23 | 2.5E+18 | 80 | 50 | 521 | 28 | 18 | 293 | <5e13 | <5e13 |
| Ex. 6 | 771 | 80 | Continuous | 500 | 6.3 | 535 | 378 | 4.7 | Not occur | 29 | 3.3E+18 | 69 | 50 | 535 | 32 | 24 | 272 | <5e13 | <5e13 |
| Ex. 7 | 770 | 80 | Continuous | 500 | 6.3 | 542 | 406 | 5.1 | Not occur | 33 | 6.9E+18 | 63 | 50 | 542 | 35 | 28 | 293 | <5e13 | <5e13 |
| Ex. 8 | 769 | 80 | Continuous | 500 | 6.3 | 537 | 394 | 4.9 | Not occur | 29 | 7.1E+18 | 68 | 50 | 537 | 31 | 29 | 284 | <5e13 | <5e13 |
| Ex. 9 | 765 | 80 | Continuous | 500 | 6.3 | 526 | 412 | 5.2 | Not occur | 28 | 1.0E+19 | 64 | 50 | 526 | 29 | 18 | 315 | <5e13 | <5e13 |
| Ex. 10 | 765 | 80 | Intermittent | 500 | 6.3 | 533 | 433 | 5.4 | Not occur | 42 | 1.1E+19 | 59 | 50 | 533 | 28 | 12 | 343 | <5e13 | <5e13 |
| Compar- ative ex. 1 | 765 | 80 | Not conducted | 0 | 0 | 520 | 462 | 5.8 | Occur | 62 | 1.2E+19 | 52 | 50 | 520 | 24 | 21 | 367 | <5e13 | <5e13 |

(Examples 11-18 and Comparative example 2)

Self-supporting ZnO single crystals were obtained by substantially the same methods as in Example 1 except that $Al_2O_3$ was put into the Pt crucible and the compositions of the materials were as shown in Table 3. In Example 18, the shaft was pulled up intermittently instead of continuously. Namely, the step of stopping the shaft and pulling up the shaft by 100 $\mu$m after 16 hours was repeated 5 times, and thus the shaft was pulled up by a total of 500 $\mu$m in 80 hours. Table 4 shows the physical properties of the obtained self-supporting films. As the amount of $Al_2O_3$ was increased, the carrier concentration was increased. In the case of the self-supporting film in Example 17, in which 2200 ppm of $Al_2O_3$ was put with respect to ZnO, the carrier concentration was $1.0 \times 10^{19}$ pieces/cm³. These results show that by putting $Al_2O_3$, the carrier concentration can be controlled to be from $2.0 \times 10^{17}$ pieces/cm³ to $1.2 \times 10^{19}$ pieces/cm³ In Example 11 with no $Al_2O_3$, the carrier mobility was 163 cm²/V·sec., whereas in Example 15 with 2200 ppm of $Al_2O_3$, the carrier mobility was 95 cm²/V·sec. This is considered to have occurred as a result of the crystal being doped with Al, which is a foreign substance. The rocking curve half width of the (002) plane, which shows the crystallinity, was 19 to 52 arcsec when the amount of $Al_2O_3$ was 0 to 2179 ppm. This shows that the crystallinity is very high. In Examples 12 through 17, the film was polished and removed by 13 to 24 $\mu$m at the -c plane, which is the growth plane on the side of the hydrothermally synthesized substrate. As a result, the Li concentration was equal to or less than $5 \times 10^{13}$ pieces/cm³, which is the lower limit for SIMS detection, on both of the ±c planes.

In Comparative example 2, in which the shaft was not pulled up, deposition of flux was recognized in the vicinity of the Pt jig/tool. When the grown film was detached from the Pt jig/tool, cracks were generated from the position of the jig/tool. The biggest of the pieces of the film resulting from the cracking and having a size corresponding to 5 mm × 5 mm was processed into a self-supporting state. Regarding the physical properties, such a piece in Comparative example 2 was not much different from the film in Example 17. Comparing Examples 17 and 18 which are different from each other only in the pull-up mechanism, the crystallinity was lower and the carrier mobility was lower in Example 18 in which the shaft was pulled up intermittently. A conceivable reason for this is that because the shaft was pulled up intermittently, the LPE film was not grown stably.

The above-described results show that when the LPE growth is performed while the shaft is pulled up continuously or intermittently, the deposition of flux from the position of the Pt jig/tool is suppressed and as a result, generation of cracks during the step of growing the film or processing the film into a self-supporting state can be reduced. In the case where after the LPE growth, the substrate used for the growth is removed by polishing and the LPE-grown film was polished by at least 10 $\mu$m at the -c plane on the side of the hydrothermally synthesized substrate, the Li concentration of the LPE film can be made $1 \times 10^{15}$ pieces/cm³ or less. Meanwhile, by controlling the amount of $Al_2O_3$, the carrier concentration of the self-supporting ZnO single crystal wafer can be controlled to be from about $2.0 \times 10^{17}$ pieces/cm³ to $1 \times 10^{19}$ pieces/cm³. Therefore, when being used as a substrate of an optical element or an electronic element, this self-supporting film acts as a conductive self-supporting substrate, which is more advantageous than an insulating substrate in terms of device production cost and length of life.

Table 3

| | Amount (g) | | | | Amount (mol) | | | | Solute composition | | Solvent composition (mol%) | |
|---|---|---|---|---|---|---|---|---|---|---|---|---|
| | PbO | $Bi_2O_3$ | ZnO | $Al_2O_3$ | PbO | $Bi_2O_3$ | ZnO | $Al_2O_3$ | Solute concentration converted to ZnO (mol%) | $Al_2O_3 *2/ZnO+Al_2O_3 *2$ (ppm) | PbO (mol%) | $Bi_2O_3$ (mol%) |
| EX. 11 | 754.12 | 722.50 | 30.18 | 0.0000 | 3.38 | 1.55 | 0.37 | 0.00E+00 | 7.00 | 0 | 68.6 | 31.4 |
| Ex. 12 | 754.12 | 722.50 | 30.18 | 0.0010 | 3.38 | 1.55 | 0.37 | 9.81E-06 | 7.00 | 53 | 68.6 | 31.4 |
| Ex. 13 | 754.12 | 722.50 | 30.18 | 0.0022 | 3.38 | 1.55 | 0.37 | 2.16E-05 | 7.00 | 120 | 68.6 | 31.4 |
| Ex. 14 | 754.12 | 722.50 | 30.18 | 0.0032 | 3.38 | 1.55 | 0.37 | 3.14E-05 | 7.00 | 170 | 68.6 | 31.4 |
| Ex. 15 | 754.12 | 722.50 | 30.18 | 0.0052 | 3.38 | 1.55 | 0.37 | 5.10E-05 | 7.00 | 280 | 68.6 | 31.4 |
| Ex. 16 | 754.12 | 722.50 | 30.18 | 0.0210 | 3.38 | 1.55 | 0.37 | 2.06E-04 | 7.00 | 1100 | 68.6 | 31.4 |
| Ex. 17 | 754.12 | 722.50 | 30.18 | 0.0412 | 3.38 | 1.55 | 0.37 | 4.04E-04 | 7.00 | 2200 | 68.6 | 31.4 |
| Ex. 18 | ↑ | ↑ | ↑ | ↑ | ↑ | ↑ | ↑ | ↑ | ↑ | ↑ | ↑ | ↑ |
| Comparative ex. 2 | ↑ | ↑ | ↑ | ↑ | ↑ | ↑ | ↑ | ↑ | ↑ | ↑ | ↑ | ↑ |

Table 4

| | Growth temperature | Growth time | Shaft pull-up | | | Substrate thickness | LPE film thickness | Growth rate | Crack generation | Rocking curve half width | Conductivity | | | Grinding | | Polishing | | Self-supporting film | Li concentration | |
|---|---|---|---|---|---|---|---|---|---|---|---|---|---|---|---|---|---|---|---|---|
| | | | System | Pull-up width | Pull-up rate | | | | | (002) plane | Carrier concentration | Carrier mobility | LPE film | Substrate | +c | -c | | | +c | -c |
| | °C | hr | | μm | μm/hr | μm | μm | μm/hr | | arcsec | pieces/cm³ | cm²/Vs | μm | μm | μm | μm | μm | pieces/cm³ | |
| Ex. 11 | 793 | 80 | Continuous | 500 | 6.3 | 524 | 421 | 5.3 | Not occur | 41 | 2.0E+17 | 163 | 50 | 524 | 25 | 22 | 324 | <5e13 | <5e13 |
| Ex. 12 | 792 | 80 | Continuous | 500 | 6.3 | 523 | 398 | 5.0 | Not occur | 41 | 1.2E+18 | 122 | 50 | 523 | 32 | 24 | 292 | <5e13 | <5e13 |
| Ex. 13 | 793 | 80 | Continuous | 500 | 6.3 | 524 | 386 | 4.8 | Not occur | 52 | 2.3E+18 | 106 | 50 | 524 | 24 | 19 | 293 | <5e13 | <5e13 |
| Ex. 14 | 792 | 80 | Continuous | 500 | 6.3 | 537 | 403 | 5.0 | Not occur | 19 | 2.5E+18 | 108 | 50 | 537 | 27 | 15 | 311 | <5e13 | <5e13 |
| Ex. 15 | 792 | 80 | Continuous | 500 | 6.3 | 538 | 415 | 5.2 | Not occur | 19 | 3.3E+18 | 108 | 50 | 538 | 22 | 23 | 320 | <5e13 | <5e13 |
| Ex. 16 | 783 | 80 | Continuous | 500 | 6.3 | 519 | 422 | 5.3 | Not occur | 37 | 7.1E+18 | 101 | 50 | 519 | 31 | 16 | 325 | <5e13 | <5e13 |
| Ex. 17 | 777 | 80 | Continuous | 500 | 6.3 | 520 | 433 | 5.4 | Not occur | 44 | 1.0E+19 | 95 | 50 | 520 | 29 | 13 | 341 | <5e13 | <5e13 |
| Ex. 18 | 777 | 80 | Intermittent | 500 | 6.3 | 519 | 461 | 5.8 | Not occur | 52 | 1.1E+19 | 88 | 50 | 519 | 27 | 14 | 370 | <5e13 | <5e13 |
| Comparative ex. 2 | 777 | 80 | Not conducted | 0 | 0 | 505 | 451 | 5.6 | Occur | 67 | 1.1E+19 | 71 | 50 | 505 | 23 | 19 | 359 | <5e13 | <5e13 |

(Examples 19-22)

Self-supporting ZnO single crystals were obtained by substantially the same methods as in Example 1 except that $In_2O_3$ was put into the Pt crucible and the compositions of the materials were as shown in Table 5. Table 6 shows the physical properties of the obtained self-supporting films. As the amount of $In_2O_3$ was increased, the carrier concentration was increased. In the case of the self-supporting film in Example 22, in which 140 ppm of $In_2O_3$ was put with respect to ZnO, the carrier concentration was $3.5 \times 10^{17}$ pieces/cm³. These results show that by putting $In_2O_3$, the carrier concentration can be controlled to be from $2.0 \times 10^{17}$ pieces/cm³ to $3.5 \times 10^{17}$ pieces/cm³ In Example 19 with no $In_2O_3$, the carrier mobility was 168 cm²/V·sec., whereas in Example 22 with 140 ppm of $In_2O_3$, the carrier mobility was 134cm²V·sec. This is considered to have occurred as a result of the crystal being doped with In, which is a foreign substance. The rocking curve half width of the (002) plane, which shows the crystallinity, was 19 to 58 arcsec when the amount of $In_2O_3$ was 0 to 140 ppm. This shows that the crystallinity is very high. In Examples 19 through 22, the film was polished and removed by 19 to 24 μm at the -c plane, which is the growth plane on the side of the hydrothermally synthesized substrate. As a result, the Li concentration was equal to or less than $5 \times 10^{13}$ pieces/cm³, which is the lower limit for SIMS detection, on both of the ±c planes.

The above-described results show that when the LPE growth is performed while the shaft is pulled up continuously or intermittently, the deposition of flux from the position of the Pt jig/tool is suppressed and as a result, generation of cracks during the step of growing the film or processing the film into a self-supporting state can be reduced. In the case where after the LPE growth, the substrate used for the growth is removed by polishing and the LPE-grown film was polished by at least 10 μm at the -c plane on the side of the hydrothermally synthesized substrate, the Li concentration of the LPE film can be made $1 \times 10^{15}$ pieces/cm³ or less. Meanwhile, by controlling the amount of $In_2O_3$, the carrier concentration of the self-supporting ZnO single crystal wafer can be controlled to be from about $2.0 \times 10^{17}$ pieces/cm³ to $3.5 \times 10^{17}$ pieces/cm³. Therefore, when being used as a substrate of an optical element or an electronic element, this self-supporting film acts as a conductive self-supporting substrate, which is more advantageous than an insulating substrate in terms of device production cost and length of life.

Table 5

| | Amount (g) | | | | Amount (mol) | | | | Solute composition | | Solvent composition | |
|---|---|---|---|---|---|---|---|---|---|---|---|---|
| | PbO | $Bi_2O_3$ | ZnO | $In_2O_3$ | PbO | $Bi_2O_3$ | ZnO | $In_2O_3$ | Solute concentration converted to ZnO (mol%) | $In_2O_3*2/ZnO+In_2O_3*2$(ppm) | PbO mol% | $Bi_2O_3$ mol% |
| Ex. 19 | 829.53 | 794.75 | 33.20 | 0.0000 | 3.717 | 1.706 | 0.408 | 0.00E+00 | 7.00 | 0.0 | 68.5 | 31.5 |
| Ex. 20 | 829.53 | 794.75 | 33.20 | 0.0016 | 3.717 | 1.706 | 0.408 | 5.76E-06 | 7.00 | 28 | 68.5 | 31.5 |
| Ex. 21 | 829.53 | 794.75 | 33.20 | 0.0030 | 3.717 | 1.706 | 0.408 | 1.08E-05 | 7.00 | 53 | 68.5 | 31.5 |
| Ex. 22 | 829.53 | 794.75 | 33.20 | 0.0080 | 3.717 | 1.706 | 0.408 | 2.88E-05 | 7.00 | 140 | 68.5 | 31.5 |

Table 6

| | Growth temper-ature | Growth time | Shaft pull-up | | | Substrate thickness | LPE film thickness | Growth rate | Crack generation | Rocking curve half width (002) plane | Conductivity | | Grinding | | Polishing | | Self-supporting film | Li concentration | |
|---|---|---|---|---|---|---|---|---|---|---|---|---|---|---|---|---|---|---|---|
| | | | System | Pull-up width | Pull-up rate | | | | | | Carrier concentra-tion | Carrier mobility | LPE film | Substrate | +c | -c | | +c | -c |
| | °C | hr | | µm | µm·hr | µm | µm | µm/hr | | arcsec | pieces/cm³ | cm²/Vs | µm | µm | µm | µm | µm | pieces/cm³ | |
| Ex. 19 | 793 | 80 | Continuous | 500 | 6.3 | 514 | 375 | 4.7 | Not occur | 33 | 2.0E+17 | 168 | 50 | 514 | 25 | 24 | 276 | <5e13 | <5e13 |
| Ex. 20 | 792 | 80 | Continuous | 500 | 6.3 | 515 | 365 | 4.6 | Not occur | 27 | 2.1E+01 | 146 | 50 | 515 | 24 | 19 | 272 | <5e13 | <5e13 |
| Ex. 21 | 792 | 80 | Continuous | 500 | 6.3 | 515 | 359 | 4.5 | Not occur | 19 | 2.3E+17 | 146 | 50 | 515 | 27 | 21 | 261 | <5e13 | <5e13 |
| Ex. 22 | 786 | 80 | Continuous | 500 | 6.3 | 515 | 371 | 4.6 | Not occur | 58 | 3.5E+17 | 134 | 50 | 515 | 23 | 23 | 275 | <5e13 | <5e13 |

(Example 23)

By the following steps, a ZnO single crystal was produced using a liquid phase epitaxial growth method. Into a platinum crucible having an inner diameter of 75 mmΦ, a height of 75 mmh and a thickness of 1 mm, ZnO, $PbF_2$ and PbO as materials were put in respective amounts of 32.24 g, 922.58 g and 839.88 g. At this point, the concentration of ZnO as a solute was 5 mol%, and the concentrations of $PbF_2$ and PbO forming a solvent were represented by $PbF_2$: PbO = 50 mol%:50.0 mol%. The crucible accommodating the materials were set in the hearth shown in FIG. 4. While the temperature of the bottom of the crucible was kept at about 940°C for 1 hour, the materials were stirred by a Pt stirring jig to be melted. Then, the temperature was lowered until the temperature of the bottom of the crucible became about 835°C. After this, a ZnO single crystal substrate grown by a hydrothermal synthesis method and having +c plane orientation and a size of 10 mm × 10 mm × 529 µmt was used as a seed crystal and brought into contact with the melt. While the pull-up shaft was rotated at 30 rpm, the crystal was grown at the same temperature for 80 hours. The set temperatures of H1, H2 and H3 were lowered at a rate of -0.1°C/hr while the offset difference was maintained. During the LPE growth, namely, for 80 hours, the pull-up shaft was continuously pulled up by about 500 µm. The pull-up rate of the shaft in this step was about 6.3 µm/hr. In this step, the rotation direction of the shaft was reversed every 2 minutes. Then, the substrate was separated from the melt by raising the pull-up shaft, and the melt component was shaken off by rotating the shaft at 100 rpm. Then, the substrate was gradually cooled down to room temperature. Thus, a colorless and transparent ZnO single crystal was obtained. The grown film was taken out from the LPE hearth after being cooled down to room temperature, and an area around the Pt jig/tool was observed. No deposition of flux was recognized. The thickness of the LPE-grown film was 343 µm, and the growth rate of this film was about 4.3 µm/hr. Next, the following processing was performed for putting the film into a self-supporting state. A rear surface of the film (-c plane side of the hydrothermally synthesized substrate) was fixed to a ceramic plate with wax. The other surface of the LPE-grown film on the side of the +c plane was ground by about 50 µm to be flat using a horizontal plane grinder. Then, the film was turned inside out and fixed to the ceramic plate, and was ground by a thickness corresponding to the thickness of the hydrothermally synthesized substrate. Thus, a self-supporting ZnO single crystal was obtained. The thickness was about 251 µm. The self-supporting film was fixed again to the ceramic plate with wax, wrapped with diamond slurry, and polished with colloidal silica. The amount polished away from the self-supporting film was 24 µm on the +c plane and 18 µm on the -c plane. As a result, a self-supporting ZnO single crystal having a thickness of about 251 µm was obtained. During the step of grinding and polishing, cracks were not generated. After the film was processed into a self-supporting state, the ±c planes were analyzed by dynamic SIMS to find the Li concentration. On both of the ±c planes, the Li concentration was equal to or less than $5 \times 10^{13}$ pieces/cm³, which is the lower limit for detection. The rocking curve half width of the (002) plane, which shows that the crystallinity of the self-supporting film, was about 31 arcsec. This indicates that the crystallinity is high. The carrier concentration, which shows the conductivity, is $1.0 \times 10^{19}$ pieces/cm³, and the carrier mobility was 60 cm²/V·sec. Such a high carrier mobility also shows that the quality is high. The flatness of an area enclosed by four 50 µm-long sides in a central part of the self-supporting film was evaluated by AFM. The result was Ra = 0.3 nm.

In this example, although a dopant for providing conductivity to the grown ZnO was not added, the film was doped with F from $PbF_2$ used as a solvent and this is considered to have caused the film to express the conductivity. The above-described results show that even when a combination of $PbF_2$ and PbO is used as a solvent, a self-supporting ZnO single crystal can be produced with a Li concentration of $1 \times 10^{15}$ pieces/cm³ or less. Meanwhile, when such a solvent is used, F causes expression of conductivity, and so it is difficult to control the conductivity by the amount of the dopant.

Table 7

| | Growth temper- ature | Growth time | Shaft pull-up | | | Substrate thickness | LPE film thickness | Growth rate | Crack generation | Rocking curve half width | Conductivity | | Grinding | | Polishing | | Self- suppoting film | Li concentration | |
|---|---|---|---|---|---|---|---|---|---|---|---|---|---|---|---|---|---|---|---|
| | | | System | Pull-up width | Pull-up rate | | | | | (002) plane | Carrier concentra- tion | Carrier mobility | LPE film | Substrate | +c | -c | | +c | -c |
| | °C | hr | | μm | μm/hr | μm | μm | μm/hr | | arcsec | pieces/cm³ | cm²/Vs | μm | μm | μm | μm | μm | pieces/cm³ | |
| Ex. 23 | 835 | 80 | Continuous | 500 | 6.3 | 529 | 343 | 4.3 | Not occur | 31 | 1.0E+19 | 60 | 50 | 529 | 24 | 18 | 251 | <5e13 | <5e13 |

(Examples 24-25)

Table 8

| | Amount (g) | | | | Amount (mol) | | | | Solute composition | | Solvent composition | |
|---|---|---|---|---|---|---|---|---|---|---|---|---|
| | PbO | Bi$_2$O$_3$ | ZnO | Ga$_2$O$_3$ | PbO | Bi$_2$O$_3$ | ZnO | Ga$_2$O$_3$ | Solute concentra- tion converted to ZnO (mol%) | Ga$_2$O$_3$*2/ ZnO+Ga$_2$O$_3$*2 (ppm) | PbO | Bi$_2$O$_3$ |
| Ex. 9 | 829.53 | 794.75 | 33.20 | 0.0800 | 3.717 | 1.706 | 0.408 | 427E-04 | 7.00 | 2100 | 68.5 | 31.5 |
| Ex. 24 | ↑ | ↑ | ↑ | ↑ | ↑ | ↑ | ↑ | ↑ | ↑ | ↑ | ↑ | ↑ |
| Ex. 25 | ↑ | ↑ | ↑ | ↑ | ↑ | ↑ | ↑ | ↑ | ↑ | ↑ | ↑ | ↑ |

Table 9

| | Growth temperature | Growth time | Shaft pull-up | | | Substrate thickness | LPE film thickness | Growth rate | Crack generation | Rocking curve half width (002) plane | Conductivity | | Grinding | | Polishing | | Self-supporting film | Li concentration | |
|---|---|---|---|---|---|---|---|---|---|---|---|---|---|---|---|---|---|---|---|
| | | | System | Pull-up width | Pull-up rate | | | | | | Carrier concentration | Carrier mobility | LPE film | Substrate | +c | -c | | +c | -c |
| | °C | hr | | μm | μm/hr | μm | μm | μm/hr | | arcsec | pieces/cm³ | cm²/Vs | μm | μm | μm | μm | μm | pieces/cm³ | |
| Ex 9 | 765 | 80 | Continuous | 500 | 6.25 | 526 | 412 | 5.2 | Not occur | 28 | 1.0E+19 | 64 | 50 | 526 | 29 | 18 | 315 | <5e13 | <5e13 |
| Ex 24 | 765 | 80 | Continuous | 160 | 2.00 | 515 | 352 | 4.4 | Not occur | 24 | 1.1E+19 | 73 | 50 | 526 | 24 | 20 | 258 | <5e13 | <5e13 |
| Ex 25 | 765 | 40 | Continuous | 2000 | 50.00 | 514 | 351 | 8.8 | Not occur | 65 | 1.2E+19 | 53 | 50 | 526 | 23 | 21 | 257 | <5e13 | <5e13 |

Example 24 was conducted in substantially the same manner as in Example 9 except that the continuous pull-up rate of the shaft was 2.0 μm/hr. Example 25 was conducted in substantially the same manner as in Example 9 except that the continuous pull-up rate of the shaft was 50.0 μm/hr. In Examples 24 and 25, self-supporting films were produced with no generation of cracks. Regarding the physical properties of the self-supporting films obtained in Examples 24 and 25, the lattice constant and the bandgap were almost the same as those of Example 9. In Example 24 in which the growth rate was low, the rocking curve half width of the (002) plane was lower and so the crystallinity was higher. By contrast, in example 25 in which the growth rate was high, the rocking curve half width of the (002) plane was higher and so the crystallinity was lower.

Hereinafter, as processes for growing a Mg-containing ZnO mixed single crystal according to one embodiment of the present invention, processes for growing a Mg-containing ZnO mixed single crystal on a ZnO single crystal substrate using a liquid phase epitaxial growth method will be described. The present invention is not limited to any of the following examples in any way.

(Example 26)

By the following steps, a Mg-containing ZnO mixed single crystal was produced using a liquid phase epitaxial (LPE) growth method. Into a platinum crucible having an inner diameter of 75 mmΦ, a height of 75 mmh and a thickness of 1 mm, ZnO, MgO, Al$_2$O$_3$, PbO and Bi$_2$O$_3$ as materials were put in respective amounts of 32.94 g, 1.81 g, 0.002 g, 800.61 g and 834.39 g. At this point, the concentration of ZnO as a solute was 7 mol%, and the ratio of Zn and Mg was MgO/(ZnO + MgO) = 10 mol%. The concentrations of PbO and Bi$_2$O$_3$ forming a solvent were represented by PbO: Bi$_2$O$_3$ = 66. 7 mol%:33.3 mol%. The crucible accommodating the materials were set in the hearth shown in FIG. 4. While the temperature of the bottom of the crucible was kept at about 840°C for 1 hour, the materials were stirred by a Pt stirring jig to be melted. Then, the temperature was lowered until the temperature of the bottom of the crucible became about 808°C. After this, a ZnO single crystal substrate grown by a hydrothermal synthesis method and having +c plane orientation and a size of 10 mm × 10 mm × 538 μmt was used as a seed crystal and brought into contact with the melt. While the pull-up shaft was rotated at 30 rpm, the crystal was grown at the same temperature for 80 hours. The set temperatures of H1, H2 and H3 were lowered at a rate of -0.1°C/hr while the offset difference was maintained. During the LPE growth, namely, for 80 hours, the pull-up shaft was continuously pulled up by about 500 μm. The pull-up rate of the shaft in this step was about 6.3 μm/hr. In this step, the rotation direction of the shaft was reversed every 2 minutes. Then, the substrate was separated from the melt by raising the pull-up shaft, and the melt component was shaken off by rotating the shaft at 100 rpm. Then, the substrate was gradually cooled down to room temperature. Thus, a colorless and transparent Mg-containing ZnO mixed single crystal was obtained in a crack-free state. The thickness of the LPE-grown film was 397 μm, and the growth rate of this film was about 5.0 μm/hr. Next, the following processing was performed for putting the film into a self-supporting state. A rear surface of the film (-c plane side of the hydrothermally synthesized substrate) was fixed to a ceramic plate with wax. The other surface of the LPE-grown film on the side of the +c plane was ground by about 50 μm to be flat using a horizontal plane grinder. Then, the film was turned inside out and fixed to the ceramic plate, and was ground by a thickness corresponding to the thickness of the hydrothermally synthesized substrate. Thus, a self-supporting Mg-containing ZnO mixed single crystal was obtained. The thickness was about 347 μm. The self-supporting film was fixed again to the ceramic plate with wax, wrapped with diamond slurry, and polished with colloidal silica. The amount polished away from the self-supporting film was 33 μm on the + (plus) plane and 28 μm on the - (minus) plane. The flatness of an area enclosed by four 50 μm-long sides in a central part of the self-supporting film was evaluated by atomic force microscopy (AFM). The result was Ra = 0.3 nm.

Next, a front surface and a rear surface of the obtained self-supporting film were subjected to measurement of the PL-emitted wavelength distribution. Both on the front and rear surfaces, the distribution was 357.5 nm ± 0.2 nm. As converted into the bandgap, this was Eg = 3.468 eV ± 0.002 eV. In the Mg-containing ZnO mixed single crystal, when the Mg/(Zn + Mg) composition is changed by 10% ± 1% (corresponding to ±10% in the composition change), the PL-emitted wavelength is changed by about 357.5 nm $\pm$ 2.1 nm and the bandgap is changed by about 3.468 eV $\pm$ 0.20 eV. Therefore, with the self-supporting film in Example 26, the uniformity of Mg/(Zn + Mg) is about $\pm 1\%$ and the bandgap uniformity is about $\pm 0.6\%$. The obtained self-supporting film was cut vertically to the c plane, and the resultant surface was subjected to measurement of the CL-emitted wavelength distribution. The result was Eg = 3.468 eV $\pm$ 0.2 nm, which is the same as the PL-emitted wavelength distribution. The above-described results show that the uniformity of Mg/(Zn + Mg) of the self-supporting film in Example 26 is within $\pm 1\%$, and the composition uniformity is within $\pm 10\%$ in both of the planar direction and the thickness direction. Next, the front and rear surfaces of the self-supporting film and the surface obtained by cutting the self-supporting film vertically to the c plane were subjected to measurement of the Li concentration using dynamic SIMS. On all the surfaces, the Li concentration was equal to or less than $5 \times 10^{13}$ pieces/cm$^3$, which is the lower limit for detection.

Table 10 shows the LPE growth conditions, thickness which was ground and polished away, and physical properties in Example 26. The "carrier concentration" and the "carrier mobility" were measured at room temperature by a Van Der Pauw method using a hole effect/specific resistance measuring device produced by Toyo Corporation.

Table 10

| | Substrate thickness | Growth temperature | Growth time | Film thickness | Growth rate | Shaft pull-up | | Crack generation | Grinding | | Polishing | | Self-supporting film | Rocking curve half width | Lattice constant | | Band-gap | Conductivity | |
|---|---|---|---|---|---|---|---|---|---|---|---|---|---|---|---|---|---|---|---|
| | | | | | | Shaft pull-up | Pull-up rate | | LPE film | Subtrate | +c | -c | | (002) plane | c axis | a axis | | Carrier concen-tration | Carrier mobility |
| | μm | °C | hr | μm | μm/hr | μm | μm/hr | | μm | μm | μm | μm | μm | arcsec | A | A | eV | pieces cm³ | cm²/V·sec |
| Ex. 26 | 538 | 808 | 80 | 397 | 5.0 | 500 | 6.3 | Not occur | 50 | 538 | 33 | 28 | 286 | 27 | 5.197 | 3.252 | 3.47 | 2.4E+18 | 90 |
| Compar-ative ex 1 | 537 | 807.8 | 80 | 385.0 | 4.81 | 500 | 6.25 | Not occur | 50 | 517 | 28 | 23 | 284 | 32 | 5.1974 | 3.2516 | 3.45 | 2.6E+18 | 88 |

(Examples 27-31)

Self-supporting films were obtained by the processes shown in Table 11 with the amount of MgO and the shaft pull-up system being changed from those of Example 26. With any of the films, the bandgap obtained from the PL-emitted wavelength was 3.32 to 3.54 eV. This shows that self-supporting Mg-containing ZnO mixed single crystal wafers having a wider bandgap than that of a hydrothermally synthesized substrate were obtained. With any of the films, the rocking curve half width of the (002) plane was 27 to 45 arcsec, which shows a high crystallinity. After the films were processed into a self-supporting state, the Li concentrations on the front and rear surfaces of all the films were equal to or less than $5 \times 10^{13}$ pieces/cm$^3$, which is the lower limit for detection.

In Example 31, the shaft was pulled up intermittently instead of continuously. The step of stopping the shaft and pulling up the shaft by 100 μm after 16 hours was repeated 5 times, and thus the shaft was pulled up by a total of 500 μm in 80 hours. The average pull-up rate was 6.3 μm/hr, which is the same as the pull-up rate in Example 30. Based on the rocking curve half width of the (002) plane, which shows the crystallinity, the crystallinity was lower in Example 31. This is considered to reflect the instability of the crystal growth which occurs when the shaft is pulled up intermittently.

Table 11

| | Substrate thickness | Growth temperature | Growth time | Film thickness | Growth rate | Shaft pull-up | | Crack generation | Grinding | | Polishing | | Self-supporting film | Rocking curve half width | Lattice constant | | Band-gap | Conductivity | | Material composition | Shaft pull-up |
|---|---|---|---|---|---|---|---|---|---|---|---|---|---|---|---|---|---|---|---|---|---|
| | | | | | | Shaft pull-up | Pull-up rate | | LPE film | Subtrate | +c | -c | | (002) plane | c axis | a axis | | Carrier concen-tration | Carrier mobility | MgO/(MgO+ZnO) | System |
| | μm | °C | hr | μm | μm/hr | μm | μm/hr | | μm | μm | μm | μm | μm | arcsec | A | A | eV | pieces cm³ | cm²/V·sec | mol% | |
| Ex. 27 | 538 | 789 | 80 | 397 | 5.0 | 500 | 6.3 | Not occur | 50 | 538 | 33 | 28 | 286 | 27 | 5.202 | 3.251 | 3.32 | 2.4E+18 | 110 | 1.2 | Continuous |
| Ex. 28 | 521 | 797 | 80 | 425 | 5.3 | 500 | 6.3 | Not occur | 50 | 521 | 30 | 26 | 319 | 28 | 5.200 | 3.251 | 3.38 | 1.2E+18 | 103 | 5.0 | Continuous |
| Ex. 29 | 520 | 815 | 80 | 406 | 5.1 | 500 | 6.3 | Not occur | 50 | 520 | 22 | 24 | 310 | 41 | 5.198 | 3.251 | 3.52 | 2.2E+18 | 71 | 13.0 | Continuous |
| Ex. 30 | 520 | 818 | 80 | 389 | 4.9 | 500 | 6.3 | Not occur | 50 | 520 | 25 | 23 | 291 | 27 | 5.195 | 3.251 | 3.54 | 2.1E+18 | 58 | 14.5 | Continuous |
| Ex. 31 | 520 | 818 | 80 | 395 | 4.9 | 500 | 6.3 | Not occur | 50 | 520 | 28 | 23 | 294 | 45 | 5.195 | 3.251 | 3.54 | 2.6E+18 | 56 | 14.5 | Intermittent |

Comparative examples 3-7

Self-supporting Mg-containing ZnO mixed single crystal wafer films were produced in the same manner as in Examples 27 through 31 except the shaft was not pulled up. In all of the grown films, deposition of flux from the position of the Pt µg/tool was recognized. In either step of growth, cooling, or grinding/polishing, cracks were generated. It is understood from the above-described results that when a thick film is grown in order to obtain a self-supporting Mg-containing ZnO mixed single crystal wafer, the deposition of flux from the position of the Pt µg/tool can be suppressed by pulling up the shaft. When the deposition of flux is suppressed, generation of cracks during the steps of growth, cooling, and grinding/polishing can be reduced.

Examples 32-33

Table 12

| | Substrate thick-ness | Growth temper-ature | Growth time | Film thick-ness | Growth rate | Shaft pull-up | | Crack generation | Grinding | | Polishing | | Self-suppoting film | Rocking curve half width | Lattice constant | | Band-gap | Conductivity | | Material compo-sition | Shaft pull-up |
| | | | | | | Shaft pull-up | Pull-up rate | | LPE film | Subtrate | +c | -c | | (002) plane | c axis | a axis | | Carrier concen-tration | Carrier mobility | MgO/(MgO+ZnO) | System |
| | µm | ℃ | hr | µm | µm/hr | µm | µm/hr | | µm | µm | µm | µm | µm | arcsec | Å | Å | eV | pieces /cm³ | cm²/V·sec | mol% | |
| Ex. 32 | 520 | 818 | 80 | 350 | 4.4 | 160 | 2.0 | Not occur | 50 | 520 | 27 | 25 | 248 | 20 | 5.195 | 3.250 | 3.54 | 2.0E+18 | 72 | 14.5 | Continuous |
| Ex. 33 | 520 | 818 | 40 | 311 | 7.8 | 2000 | 50.0 | Not occur | 50 | 520 | 25 | 24 | 212 | 60 | 5.195 | 3.251 | 3.54 | 2.3E+18 | 50 | 14.5 | Continuous |
| Comparative ex. 7 | 520 | 818.1 | 80 | 330.0 | 4.13 | 100 | 1.25 | Occur | 50 | 520 | 32 | 23 | 225 | 25 | 5.1490 | 3.2506 | 3.54 | 1.90E+18 | 75 | 14.5 | Continuous |
| Comparative ex. 8 | 520 | 818.1 | 40 | - | - | 2200 | 55 | Substrate away from melt | | | | | | | | | | | | 14.5 | Continuous |

Example 32 was conducted in substantially the same manner as in Example 31 except that the shaft was pulled up continuously instead of intermittently and the continuous pull-up rate was changed to 2.0 µm/hr. Example 33 was conducted in substantially the same manner as in Example 31 except that the shaft was pulled up continuously instead of intermittently, the continuous pull-up rate was changed to 50.0 µm/hr, and the growth time was changed to 40 hours from 80 hours. In Examples 32 and 33, self-supporting films were produced with no generation of cracks. Regarding the physical properties of the self-supporting films obtained in Examples 32 and 33, the lattice constant and the bandgap were almost the same as those of Example 31. In Example 32 in which the growth rate was low, the rocking curve half width of the (002) plane was lower and so the crystallinity was higher. By contrast, in Example 33 in which the growth rate was high, the rocking curve half width of the (002) plane was higher and so the crystallinity was lower.

INDUSTRIAL APPLICABILITY

The present invention relates to a ZnO-based semiconductor material, which is specifically usable in the field of optics and the field of electric/electronic industries.

Claims

1.    A method for producing a ZnO single crystal using a liquid phase epitaxial growth method, the method comprising the steps of:

mixing and melting ZnO as a solute and a solvent, and then bringing a seed crystal substrate into direct contact with the resultant melt; and
pulling up the seed crystal substrate continuously or intermittently to grow the ZnO single crystal on the seed crystal substrate.

2.    The method for producing a ZnO single crystal according to claim 1, wherein the solvent is a combination of PbO

and $Bi_2O_3$.

3. The method for producing a ZnO single crystal according to claim 2, wherein a mixing ratio of the solute and the solvent is solute:solvent = 5 to 30 mol%:95 to 70 mol%, and a mixing ratio of PbO and $Bi_2O_3$ forming the solvent is $PbO:Bi_2O_3$ = 0.1 to 95 mol%:99.9 to 5 mol%.

4. The method for producing a ZnO single crystal according to claim 1, wherein the solvent is a combination of $PbF_2$ and PbO.

5. The method for producing a ZnO single crystal according to claim 4, wherein a mixing ratio of the solute and the solvent is salute:solvent = 2 to 20 mol%:98 to 80 mol%, and a mixing ratio of $PbF_2$ and PbO forming the solvent is $PbF_2$:PbO = 20 80 mol%:80 to 20 mol%.

6. The method for producing a ZnO single crystal according to any one of claims 1 through 5, wherein a rate V at which the seed crystal substrate is pulled up continuously is $2\ \mu m/hr \leq V \leq 50\ \mu m/hr$.

7. The method for producing a ZnO single crystal according to any one of claims 1 through 5, wherein an average rate v at which the seed crystal substrate is pulled up intermittently is $2\ \mu m/hr \leq v \leq 50\ \mu m/hr$.

8. The method for producing a ZnO single crystal according to any one of claims 1 through 7, wherein the ZnO single crystal has a thickness of 100 $\mu$m or greater.

9. The method for producing a ZnO single crystal according to any one of claims 1 through 8, wherein the ZnO single crystal contains at least one selected from the group consisting of Al, Ga, In, H and F.

10. The method for producing a ZnO single crystal according to any one of claims 1 through 9, wherein the ZnO single crystal has a growth orientation of +c plane.

11. The method for producing a ZnO single crystal according to any one of claims 1 through 10, comprising the step of, after the ZnO single crystal is grown, removing the seed crystal substrate by polishing or etching, and polishing or etching a surface, on the side of -c plane, of the single crystal grown by liquid phase epitaxy by at least 10 $\mu$m.

12. A self-supporting ZnO single crystal wafer obtained by the method for producing a ZnO single crystal according to claim 11, wherein the self-supporting ZnO single crystal wafer has a thickness of 100 $\mu$m or greater.

13. The self-supporting ZnO single crystal wafer according to claim 12, which has a Li concentration that is uniform in a planar direction and a thickness direction of the wafer and is $1 \times 10^{15}$ pieces/cm$^3$ or less.

14. The self-supporting ZnO single crystal wafer according to claim 12 or 13, which contains Ga, and has a carrier concentration of $2.0 \times 10^{17}$ pieces/cm$^3$ to $1.0 \times 10^{19}$ pieces/cm$^3$ and a Li concentration of $1 \times 10^{15}$ pieces/cm$^3$ or less.

15. The self-supporting ZnO single crystal wafer according to claim 12 or 13, which contains Al, and has a carrier concentration of $20 \times 10^{17}$ pieces/cm$^3$ to $1.0 \times 10^{19}$ pieces/cm$^3$ and a Li concentration of $1 \times 10^{15}$ pieces/cm$^3$ or less.

16. The self-supporting ZnO single crystal wafer according to claim 12 or 13, which contains In, and has a carrier concentration of $2.0 \times 10^{17}$ pieces/cm$^3$ to $3.5 \times 10^{17}$ pieces/cm$^3$ and a Li concentration of $1 \times 10^{15}$ pieces/cm$^3$ or less.

17. A self-supporting Mg-containing ZnO mixed single crystal water, which has a plate-like shape having a thickness of 50 $\mu$m or greater and has a chemical composition of Zn and Mg that is uniform in a thickness direction and a planar direction of the plate, and in which at least one of a front surface and a rear surface thereof is sufficiently flat to allow epitaxial growth to be made thereon.

18. The self-supporting Mg-containing ZnO mixed single crystal wafer according to claim 17, which has a bandgap (Eg) value that is uniform in a planar direction and a thickness direction of the wafer and exceeds 3.30 eV.

19. The self-supporting Mg-containing ZnO mixed single crystal wafer according to claim 17 or 18, which has a Li concentration that is uniform in a planar direction and a thickness direction of the wafer and is $1 \times 10^{15}$ pieces/cm$^3$ or less.

**20.** The self-supporting Mg-containing ZnO mixed single crystal wafer according to any one of claims 17 through 19, which contains at least one selected from the group consisting of Al, Ga, In, H and F.

**21.** A method for producing a Mg-containing ZnO mixed single crystal using a liquid phase epitaxial growth method, the method comprising the steps of:

mixing and melting ZnO and MgO forming a solute and a solvent, and then bringing a seed crystal substrate into direct contact with the resultant melt; and
pulling up the seed crystal substrate continuously or intermittently to grow the Mg-containing ZnO mixed single crystal on the seed crystal substrate.

**22.** The method for producing a Mg-containing ZnO mixed single crystal according to claim 21. wherein the solvent is a combination of PbO and $Bi_2O_3$.

**23.** The method for producing a Mg-eantaining ZnO mixed single crystal according to claim 22, wherein a mixing ratio of the solute and the solvent is solute as entirely converted to ZnO:solvent = 5 to 30 mol%:95 to 70 mol%, and a mixing ratio of PbO and $Bi_2O_3$ forming the solvent is PbO:$Bi_2O_3$ = 0.1 to 95 mol%:99.9 to 5 mol%.

**24.** The method for producing a Mg-containing ZnO mixed single crystal according to claim 21, wherein the solvent is a combination of $PbF_2$ and PbO.

**25.** The method for producing a Mg-containing ZnO mixed single crystal according to claim 24, wherein a mixing ratio of the solute and the solvent is solute as entirely converted to ZnO:solvent = 2 to 20 mol%:98 to 80 mol%, and a mixing ratio of $PbF_2$ and PbO forming the solvent is $PbF_2$:PbO = 80 to 20 mol%:20 to 80 mol%.

**26.** The method for producing a Mg-containing ZnO mixed single crystal according to any one of claims 21 through 25, wherein a rate V at which the seed crystal substrate is pulled up continuously is 2 $\mu$m/hr $\leq$ V $\leq$ 50 $\mu$m/hr.

**27.** The method for producing a Mg-containing ZnO mixed single crystal according to any one of claims 21 through 25, wherein an average rate v at which the seed crystal substrate is pulled up intermittently is 2 $\mu$m/hr $\leq$ v $\leq$ 50 $\mu$m/hr.

**28.** The method for producing a Mg-containing ZnO mixed single crystal according to any one of claims 21 through 27, wherein the Mg-containing ZnO mixed single crystal has a thickness of 100 $\mu$m or greater.

**29.** The method for producing a Mg-containing ZnO mixed single crystal according to any one of claims 21 through 28, wherein the Mg-containing ZnO mixed single crystal has a growth orientation of +c plane.

**30.** The method for producing a Mg-containing ZnO mixed single crystal according to any one of claims 21 through 29, comprising the step of, after the Mg-containing ZnO mixed single crystal is grown, removing the seed crystal substrate by polishing or etching, and polishing or etching a surface, on the side of -c plane, of the single crystal grown by the liquid phase epitaxial growth method by at least 10 $\mu$m.

**31.** A method for producing a Mg-containing ZnO mixed single crystal laminate body, wherein after a self-supporting Mg-containing ZnO mixed single crystal is produced by the method for producing a Mg-containing ZnO mixed single crystal according to claim 30, this single crystal is used as a seed crystal substrate, and a ZnO single crystal or a Mg-containing ZnO mixed single crystal is further grown on the seed crystal substrate.

**32.** A self-supporting Mg-containing ZnO mixed single crystal wafer produced by the method for producing a Mg-containing ZnO mixed single crystal according to claim 30, wherein the self-supporting Mg-containing ZnO mixed single crystal wafer has a plate-like shape having a thickness of 50 $\mu$m or greater and has a chemical composition of Zn and Mg which is uniform in a thickness direction and a planar direction of the plate; and at least one of a front surface and a rear surface thereof is sufficiently flat to allow epitaxial growth to be made thereon.

**33.** The self-supporting Mg-containing ZnO mixed single crystal wafer according to claim 32, which has a bandgap (Eg) value that is uniform in a planar direction and a thickness direction of the wafer and exceeds 3.30 eV.

**34.** The self-supporting Mg-containing ZnO mixed single crystal wafer according to claim 32 or 33, which has a Li concentration that is uniform in a planar direction and a thickness direction of the wafer and is $1 \times 10^{15}$ pieces/cm$^3$

or less.

35. The self-supporting Mg-containing ZnO mixed single crystal wafer according to any one of claims 32 through 34, which contains at least one selected from the group consisting of Al, Ga, In, H and F.

Fig. 1

Fig. 2

(ẋ)  ZnO mixed single crystal having
electric conductivity

Conventional device structure

Device structure according to
the present invention

Fig. 3

Fig. 4

## INTERNATIONAL SEARCH REPORT

| International application No. |
| --- |
| PCT/JP2009/055301 |

**A. CLASSIFICATION OF SUBJECT MATTER**
*C30B29/16*(2006.01)i, *C30B19/02*(2006.01)i, *C30B33/00*(2006.01)i, *H01L21/368*(2006.01)i

According to International Patent Classification (IPC) or to both national classification and IPC

**B. FIELDS SEARCHED**

Minimum documentation searched (classification system followed by classification symbols)
C30B29/16, C30B19/02, C30B33/00, H01L21/368

Documentation searched other than minimum documentation to the extent that such documents are included in the fields searched
Jitsuyo Shinan Koho        1922-1996   Jitsuyo Shinan Toroku Koho   1996-2009
Kokai Jitsuyo Shinan Koho  1971-2009   Toroku Jitsuyo Shinan Koho   1994-2009

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | WO 2007/100146 A1 (Mitsubishi Gas Chemical Co., Inc.), 07 September, 2007 (07.09.07), Claims 1 to 4, 7; examples 2, 6, 7, 11 & EP 1997941 A1 | 1-16,21-35 |
| Y | JP 2000-302596 A (Fujikura Ltd.), 31 October, 2000 (31.10.00), Par. No. [0005] & WO 2000/063926 A1 | 1-16,21-35 |
| Y | JP 2002-009353 A (International Superconductivity Technology Center), 11 January, 2002 (11.01.02), Par. Nos. [0008], [0017], [0028] (Family: none) | 1-16,21-35 |

☒ Further documents are listed in the continuation of Box C.   ☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered   to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 04 June, 2009 (04.06.09) | 16 June, 2009 (16.06.09) |

| Name and mailing address of the ISA/ | Authorized officer |
| --- | --- |
| Japanese Patent Office | |
| Facsimile No. | Telephone No. |

Form PCT/ISA/210 (second sheet) (April 2007)

**INTERNATIONAL SEARCH REPORT**

| International application No. |
|---|
| PCT/JP2009/055301 |

C (Continuation). DOCUMENTS CONSIDERED TO BE RELEVANT

| Category* | Citation of document, with indication, where appropriate, of the relevant passages | Relevant to claim No. |
|---|---|---|
| Y | JP 63-144191 A (Sumitomo Electric Industries, Ltd.), 16 June, 1988 (16.06.88), Page 6, upper left column, lines 2 to 5 (Family: none) | 1-16,21-35 |
| Y | JP 2007-223878 A (Sumitomo Electric Industries, Ltd.), 06 September, 2007 (06.09.07), Par. Nos. [0042], [0046], [0049] (Family: none) | 11-16,30-35 |
| X Y | Jun KOBAYASHI et al., "Ekiso Epitaxy-ho ni yoru (Zn,Mg)O Komaku no Seicho", The Ceramic Society of Japan 2008 Nen Nenkai Koen Yokoshu, 20 March, 2008 (20.03.08), page 15 | 17-20 21-35 |

Form PCT/ISA/210 (continuation of second sheet) (April 2007)

33

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005072067 A
- JP 2007204324 A
- JP 2003046081 A
- WO 2007100146 A

**Non-patent literature cited in the description**

- **A. Ohtomo et al.** *Applied Physics Letters,* 11 May 1998, vol. 72 (19), 2466-2468
- **Maki et al.** *Jpn. J. Appl. Phys.,* 2003, vol. 42, 75-77
- **H. Ryoken et al.** *Journal of Crystal Growth,* 2006, vol. 287, 134-138